(19) Europäisches Patentamt
European Patent Office
Office européen des brevets

(11) EP 2 668 039 B1

# (12) EUROPEAN PATENT SPECIFICATION

(45) Date of publication and mention of the grant of the patent:
**03.06.2015 Bulletin 2015/23**

(21) Application number: **12701486.8**

(22) Date of filing: **20.01.2012**

(51) Int Cl.:
***B41C 1/10*** (2006.01) *G03F 7/09* (2006.01)

(86) International application number:
**PCT/EP2012/050838**

(87) International publication number:
**WO 2012/101046 (02.08.2012 Gazette 2012/31)**

## (54) A LITHOGRAPHIC PRINTING PLATE PRECURSOR

VORLÄUFER EINER LITHOGRAFISCHEN DRUCKPLATTE

PRECURSEUR DE PLAQUE LITHOGRAPHIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.01.2011 EP 11152109**
**28.01.2011 US 201161437036 P**

(43) Date of publication of application:
**04.12.2013 Bulletin 2013/49**

(73) Proprietor: **AGFA Graphics NV**
**2640 Mortsel (BE)**

(72) Inventors:
- **ANDRE, Xavier**
  **B-2640 Mortsel (BE)**
- **MORIAME, Philippe**
  **B-2640 Mortsel (BE)**
- **VAN AERT, Hubertus**
  **B-2640 Mortsel (BE)**

(56) References cited:
**EP-A1- 1 588 860** **EP-A2- 1 266 767**
**US-B1- 6 196 129**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 668 039 B1

**Description**

FIELD OF THE INVENTION

The present invention relates to a positive-working lithographic printing plate precursor comprising a compound including a blocked isocyanate group and an alkali soluble resin comprising a monomeric unit including a Lewis base moiety.

BACKGROUND OF THE INVENTION

Lithographic printing presses use a so-called printing master such as a printing plate, which is mounted on a cylinder of the printing press. The master carries a lithographic image on its surface and a print is obtained by applying ink to said image and then transferring the ink from the master onto a receiver material, which is typically paper. In conventional, so-called "wet" lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called driographic printing, the lithographic image consists of ink-accepting and ink-abhesive (ink-repelling) areas and during driographic printing, only ink is supplied to the master.
Printing masters are generally obtained by the image-wise exposure and processing of an imaging material called plate precursor. In addition to the well-known photosensitive, so-called pre-sensitized plates, which are suitable for UV contact exposure through a film mask, also heat-sensitive printing plate precursors have become very popular in the late 1990s. Such thermal materials offer the advantage of daylight stability and are especially used in the so-called computer-to-plate method wherein the plate precursor is directly exposed, i.e. without the use of a film mask. The material is exposed to heat or to infrared light and the generated heat triggers a (physico-)chemical process, such as ablation, polymerization, insolubilization by crosslinking of a polymer, heat-induced solubilization or particle coagulation of a thermoplastic polymer latex.
The most popular thermal plates form an image by a heat-induced solubility difference in an alkaline developer between exposed and non-exposed areas of the coating. The coating typically comprises an oleophilic binder, e.g. a phenolic resin, of which the rate of dissolution in the developer is either reduced (negative-working) or increased (positive-working) by the image-wise exposure. During processing, the solubility differential leads to the removal of the non-image (non-printing) areas of the coating, thereby revealing the hydrophilic support, while the image (printing) areas of the coating remain on the support. Typical examples of such plates are described in e.g. EP-A 625728, 823327, 825927, 864420, 894622 and 901902. Negative working embodiments of such thermal materials often require a pre-heat step between exposure and development as described in e.g. EP- 625,728.
In the graphic arts industry, there is an evolution towards the use of recycled paper and more abrasive inks, fountain solutions and/or plate cleaners. These harsh printing conditions, especially occuring on web presses, not only impose more stringent demands on the chemical resistance of the printing plates towards pressroom chemicals and inks, but also reduce the press life of the plate. In addition, printing plates are susceptible to damage caused by mechanical forces applied to the surface of the coating during for example automatic transport, mechanical handling, manual handling and/or printing. Mechanical damage may result in a reduced printing quality due to destruction of the surface of the coating of the printing plate and/or also to a reduced press life. To improve the chemical resistance, the press life and/or the robustness of positive-working plates based on oleophilic resins, often a heat-treatment is carried out after the exposure and development steps. Other solutions to these issues have been provided in the art by optimizing the coatings for example by selection of specific alkaline soluble resins - e.g. by chemical modification - and/or by providing double layer coatings. Such coatings typically include a first layer comprising a highly solvent resistant alkaline soluble resin and a second layer on top of this first layer comprising a phenolic resin for image formation. However, despite the solutions provided in the art, there is still a need for positive-working printing plates which are characterized by an improved durability and runlength (press life).
EP-A-1588860 discloses a printing plate material comprising a support and provided thereon, a hydrophilic layer and a thermosensitive image formation layer containing a blocked isocyanate compound, which is a reaction product of an isocyanate compound, a polyol, and an isocyanate group-blocking material.

SUMMARY OF THE INVENTION

It is an object of the present invention to provide a positive-working lithographic printing plate with a high chemical and/or mechanical resistance.
A high chemical resistance means that the coating is not, or substantially not, affected by printing liquids such as ink, e.g. UV-ink, fountain solution, plate and blanket cleaners. A high mechanical resistance means that the printing

plate is protected against mechanical damage occurring during plate handling and/or printing.

The object of the present invention is realized by claim 1, i.e. a lithographic printing plate precursor which comprises on a support having a hydrophilic surface or which is provided with a hydrophilic layer, a heat and/or light-sensitive coating including an infrared absorbing agent, a compound including a blocked isocyanate group and an alkali soluble resin comprising at least one monomeric unit including a Lewis base moiety.

It was surprisingly found that a printing plate including a coating containing a compound including a blocked isocyanate group combined with an alkali soluble binder including a monomeric unit including a Lewis base moiety exhibits a high chemical resistance against press liquids and/or treating liquids, and/or a high mechanical resistance which prevents damages occurring during printing and/or plate handling.

Other features, elements, steps, characteristics and advantages of the present invention will become more apparent from the following detailed description of preferred embodiments of the present invention. Specific embodiments of the invention are also defined in the dependent claims.

DETAILED DESCRIPTION OF THE INVENTION

The lithographic printing plate precursor according to the present invention comprises on a support having a hydrophilic surface or which is provided with a hydrophilic layer, a heat and/or light sensitive coating and is positive-working, i.e. after exposure and development the exposed areas of the coating are removed from the support and define hydrophilic (non-printing) areas, whereas the unexposed coating is not removed from the support and defines oleophilic (printing) areas.

The coating comprises a compound including a blocked isocyanate group. The compound includes at least one blocked isocyanate group, preferably at least two blocked isocyanate groups, more preferably at least three blocked isocyanate groups and most preferably at least four blocked isocyanate groups. Alternatively, the compound including a blocked isocyanate group may be a (co)polymer including up to 100 blocked isocyanate groups preferably up to 80 blocked isocyanate groups, more preferably up to 60 blocked isocyanate groups and most perefarbly up to 30 blocked isocyanate groups. A blocked isocyanate group is a functional isocyanate group which has reacted with a blocking group such as for example an optionally substituted amine, oxime, phenol, thiophenol, pyridinol, caprolactam, amide, cyclic amide, imide, acetanilide, imidazole, amidine, N-hydroxyimide, triazole, pyrazole, or mercaptopyridine group. Under the influence of heat, the blocked isocyanate group can be deprotected resulting in a reactive, free isocyanate group and the blocking group. Subsequently, this deprotected, reactive isocyanate group can react with a Lewis base such as a nucleophile, for example a compound or (co)polymer including an amine (e.g. primary amines and secondary amines), a hydroxyl, a phenol, a thiol or an oxirane group to form a final product. Alternatively, under the influence of heat, the blocked isocyanate group reacts directly with for example a nucleophile to yield a tetrahedral intermediate followed by elimination of the blocking group.

The structure of the blocking group has a major effect on the deblocking temperature - i.e. the temperature at which the blocked isocyanate group can be deprotected - and/or the reaction rate of the free isocyanate group. For example, steric hindrance (in general, the higher the steric hindrance of a blocking group the lower the deblocking temperature) and/or the electron-withdrawing potential of the blocking group (in general, the greater the electron-withdrawing potential of a blocking group, the lower the deblocking temperature) have an influence on the deblocking temperature of the blocked isocyanate compound. It is believed that the compound including a blocked isocyanate group according to the present invention does not deblock during coating, drying, imaging and/or developing. Preferably, the compound including the blocked isocyanate group has a deblocking temperature above 90°C, more preferably above 95°C, even more preferably above 100°C and most perferably above 110°C. The deblocking temperature is the temperature at which free isocyanate groups are formed or in other words, the blocked isocyanate group deblocks. The deblocking temperature can be measured as for example disclosed in the Examples below.

In a preferred embodiment the compound including a blocked isocyanate group can be represented by structure I:

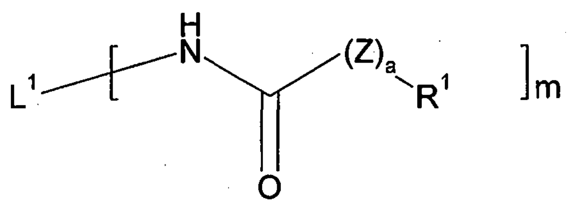

structure I

wherein

m represents an integer comprised between 2 and 100; preferably m represents an integer comprised between to 2 and 50; most preferably m represents an integer equal to 2, 3, 4 or 5;

a represents 0 or 1;

$L^1$ represents a mono-, bi-, tri- or multivalent linking group;

Z is selected from oxygen, thiol, -NH- or -$NR^w$- wherein $R^w$ represents an optionally substituted alkyl group;

$R^1$ represents hydrogen, an optionally substituted alkyl, alkenyl, alkynyl, alicyclic, aralkyl, alkaryl, aryl or heteroaryl group such as a pyrazoyl, caprolactyl, pyridyl, pyrimidyl or pyridazyl group, an aldoxime group (-O-N=$CHR^a$) wherein $R^a$ represents an alkyl group, or a ketoxime group (-ON=$CR^bR^c$) wherein $R^b$ and $R^c$ independently represent an optionally substituted alkyl group, $R^b$ and $R^c$ may be linked.

Preferably, $R^1$ represents an optionally substituted pyrazoyl, caprolactyl or a ketoxime, or a combination thereof. Most preferably, $R^1$ represents 3,5-dimethylpyrazoyl, methylethylketoxime, epsilon caprolactyl or a combination thereof.

Preferably, $L^1$ represents a mono-, bi-, tri- or multivalent linking group selected from an optionally substituted alkylene, alkenylene, alkynylene, aralkylene, arylene, heteroarylene, hexamethylene, phenylene, biphenylene, tolyl, xylyl, diphenylmethane, isophorone or triazine group, an alicyclic or heterocyclic group, a core based on hexamethylene diisocyanate (HDI) isocyanurate trimer (for example figure 1 below), a core based on hexamethylene diisocyanate (HDI) biuret (for example figure 2 below), a core based on isophorone diisocyanate (IPDI) (for example figure 3 below), a core based on an optionally substituted hexamethylene diisocyanate (HDI) (for example figure 4 below), a core based on toluene diisocyanate (TDI) (for example figure 5 below), a core based on methylene diphenyl diisocyanate (MDI) or combination (for example figures 6, 7 and 8 below), a core based on tetramethylxylene diisocyanate (TMXDI) (for example figure 9 below), a core based on phenylene diisocyanate (for example figures 10 and 11 below), a core based on biphenylene diisocyanate or derivatives thereof (for example figures 12, 13 and 14 below), a core based on xylylene diisocyanate (for example figure 15 below), a core based on HDI:TDI isocyanurate (for example figure 16 below), a core based on isophorone diisocyanate (IPDI) isocyanurate trimer (for example figure 17 below), any multifunctional core such as a polymeric diphenylmethane made from diphenylmethane diisocyanate or methylene diphenyl diisocyanate (for example figure 18 below), a core based on 1,3-bis(isocyanatomethyl)cyclohexane ($H_6XDI$), a core based on naphthalene diisocyanate (NDI) or derivatives thereof, a core based on o-tolidine diisocyanate (TODI), a core based on cyclohexane diisocyanate (CHDI) or a core based on 4,4'-diisocyanatodicyclohexylmethane ($H_{12}MDI$), $L^1$ may be part of a polymer or a copolymer structure such as a polyamine, polyalkyleneimine, polyaniline or derivatives thereof, polyphenol, polystyrene, polyester, polyamide, polyalcohol, poly(meth)acryl, or poly(meth)acrylate or combination thereof;

More preferably, $L^1$ is selected from a core based on an optionally substituted hexamethylene diisocyanate (HDI) (for example figure 4 below), a core based on toluene diisocyanate (TDI) (for example figure 5 below), a core based on methylene diphenyl diisocyanate (MDI) or combination (for example figures 6, 7 and 8 below), a core based on tetramethylxylene diisocyanate (TMXDI) (for example figure 9 below), a core based on phenylene diisocyanate (for example figures 10 and 11 below), a core based on biphenylene diisocyanate or derivatives thereof (for example figures 12, 13 and 14 below), a core based on xylylene diisocyanate (for example figure 15 below).

In a most preferred embodiment, a core based on hexamethylene diisocyanate (HDI) isocyanurate trimer (for example figure 1 below), a core based on hexamethylene diisocyanate (HDI) biuret (for example figure 2 below), a core based on HDI:TDI isocyanurate (for example figure 16 below) or a core based on isophorone diisocyanate (IPDI) isocyanurate trimer (for example figure 17 below).

Most preferably, $L^1$ has one of the following structures as shown in the Table below.

| | | |
|---|---|---|
| 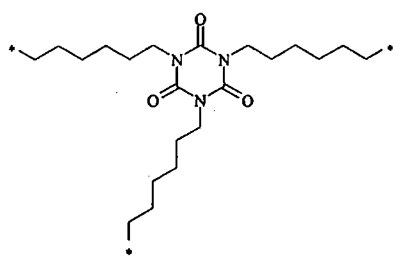 Figure 1 | 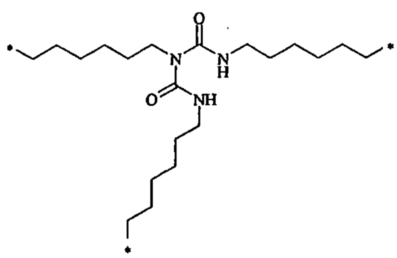 Figure 2 | 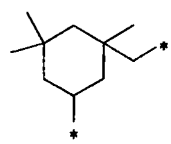 Figure 3 |

(continued)

| | | |
|---|---|---|
| 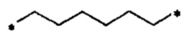 Figure 4 | 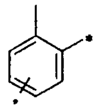 Figure 5 | 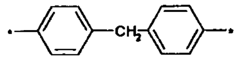 Figure 6 |
| 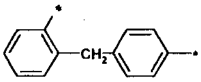 Figure 7 | 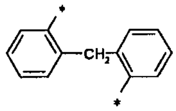 Figure 8 | 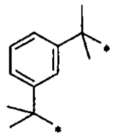 Figure 9 |
| 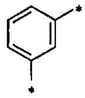 Figure 10 | 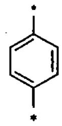 Figure 11 | 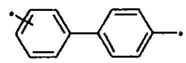 Figure 12 |
| 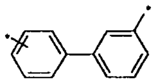 Figure 13 | 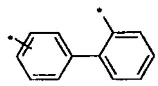 Figure 14 | 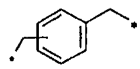 Figure 15 |
| 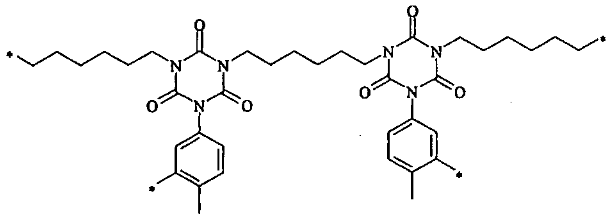 Figure 16 | | 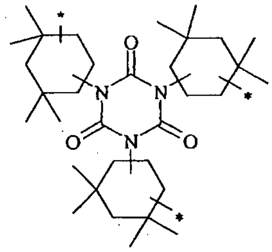 Figure 17 |
| 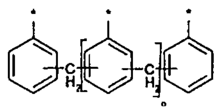 Figure 18 | | |
| *: via this bond $L^1$ is attached to -[NH-CO-$(Z)_a$-$R^1$]$_m$ in structure I and to -[O-CO-NH-$R^2$]$_p$ in structure II below. | | |

In an alternative embodiment, the compound including a blocked isocyanate group can be represented by structure II:

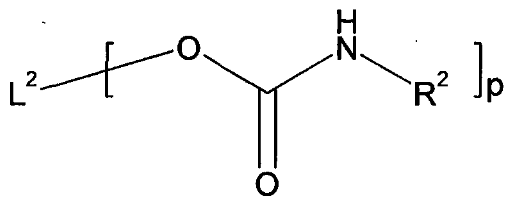

structure II

wherein

$L^2$, $R^2$ and p are as defined above as for respectively $L^1$, $R^1$ and m. The preferred structures 1 to 18 for $L^2$ are as described above and as shown in the Table above.

The optional substituents on $L^1$, $L^2$, $R^1$ and $R^2$ are selected from hydrogen, an optionally substituted straight, branched or cyclic alkyl group such as methyl, ethyl, propyl, isopropyl, butyl, tertiary butyl, pentyl, cyclopentyl, cyclohexyl or adamantyl group, an aryl group such as a phenyl, a benzyl, a tolyl, an ortho- meta- or para-xylyl, naphtalenic, an anthracenic, a phenanthrenic or a carbazoyl group, an aralkyl or hetero-aralkyl group, an alkoxy or aryloxy group, a thio alkyl, thio aryl or thio heteroaryl group, a (di)alkylamine group, a heteroaryl group such as a pyridyl, pyrimidyl, pyrazoyl or pyridazyl group, a hydroxyl group, -SH, a carboxylic acid group or an alkyl ester thereof, a sulphonic acid group or an alkyl ester thereof, a phosphonic acid group or an alkyl ester thereof, a phosphoric acid group or an alkyl ester thereof, a sulphonamide group, an amide group, a nitro group, a nitrile group a halogen or a combination of at least two of these groups, including at least one of these groups which is further substituted by one of these groups and/or combination thereof.

The level of the compound including a blocked isocyanate group in the coating is preferably between 0.005 and 1.0 $g/m^2$, 0.01 and 0.50 $g/m^2$; more preferably between 0.03 and 0.15 $g/m^2$ and most preferably between 0.05 and 0.10 $g/m^2$.

Typical examples of compounds including a blocked isocyanate group according to our invention are given in the Table below without being limited thereto.

| | |
|---|---|
| 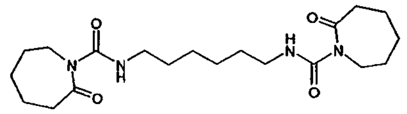 | 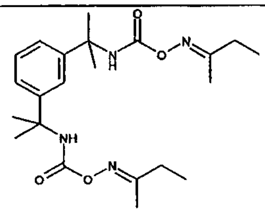 |
| 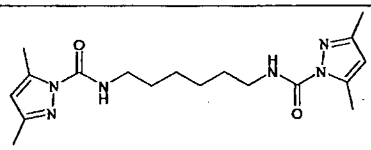 | 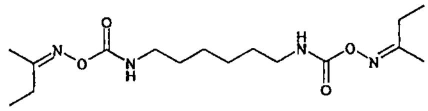 |
| 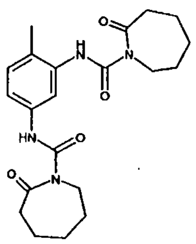 | 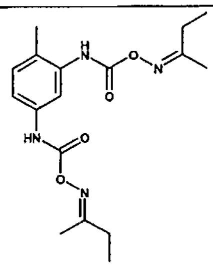 |
| 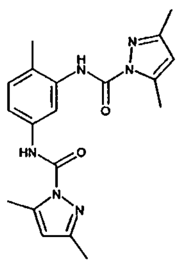 | 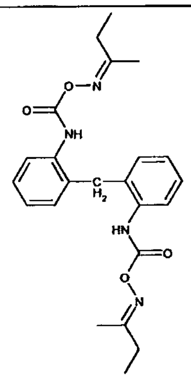 |
| 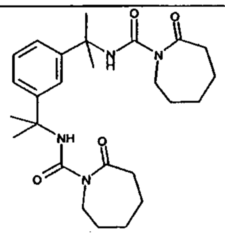 | 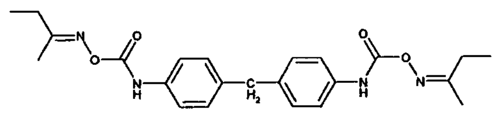 |

| | |
|---|---|
| 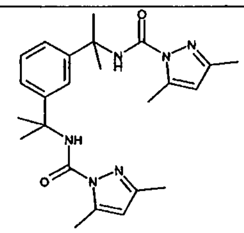 | 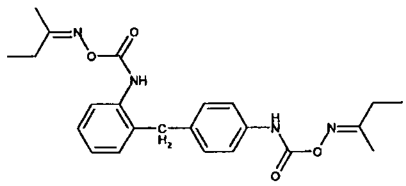 |
| 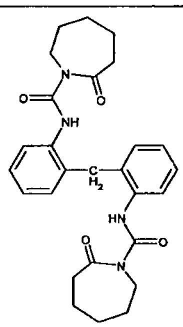 | 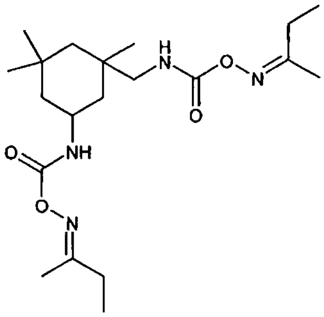 |
| 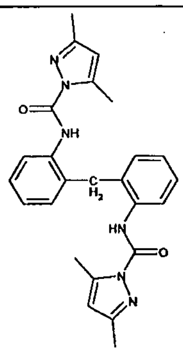 | 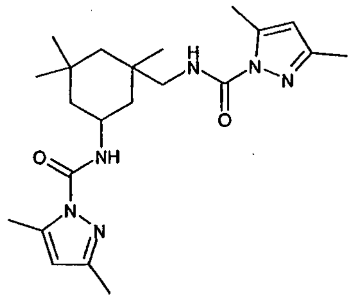 |
| 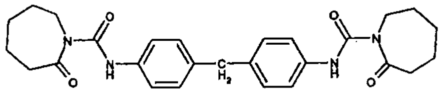 | 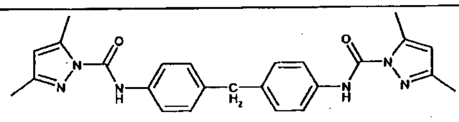 |
| 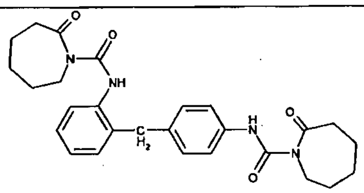 | 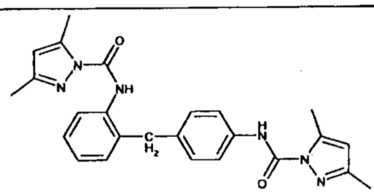 |
| 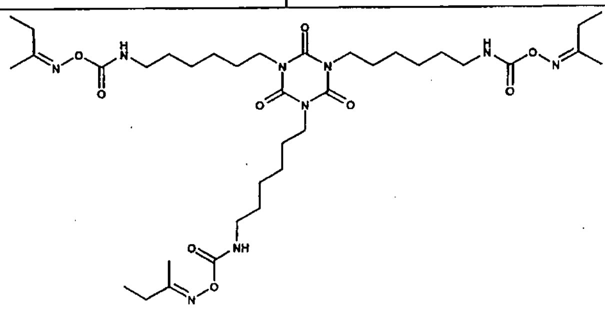 | |

| |
|---|
| 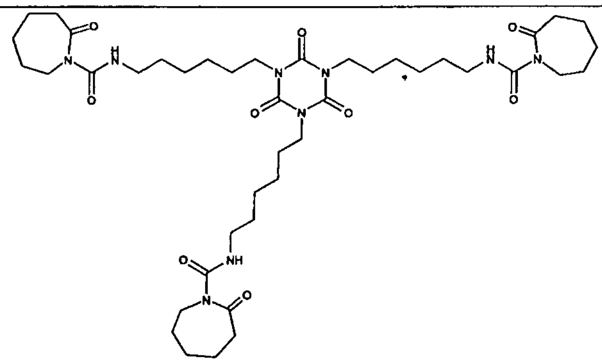 |
| 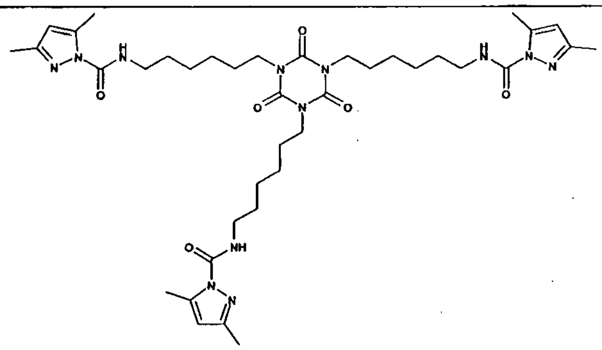 |
| 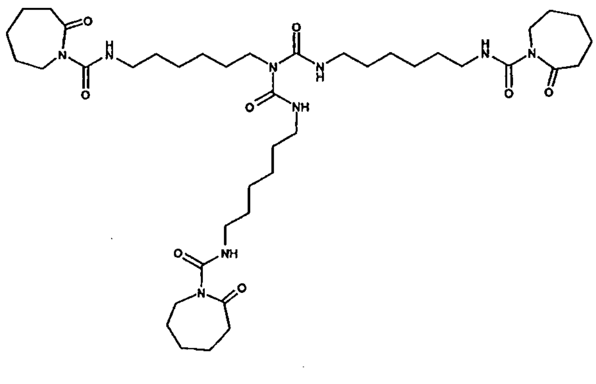 |
| 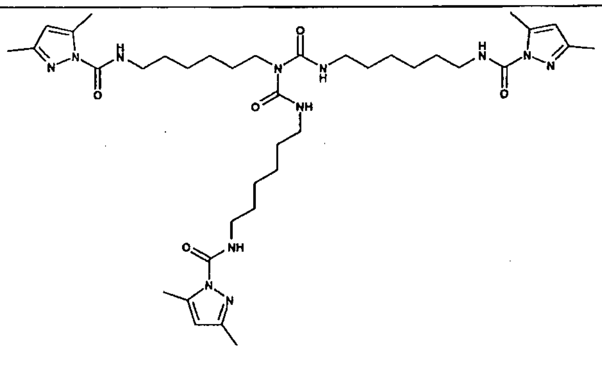 |

| | |
|---|---|
| 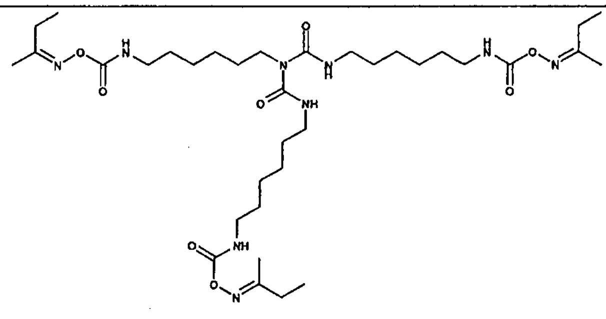 | |
| 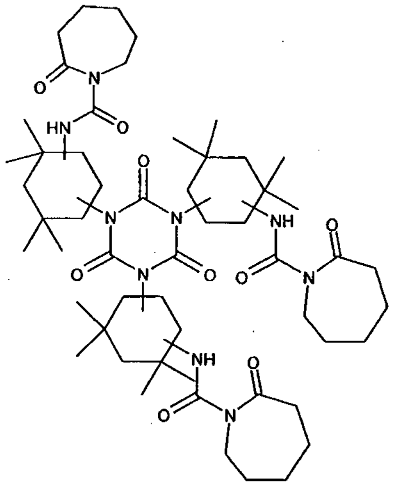 | 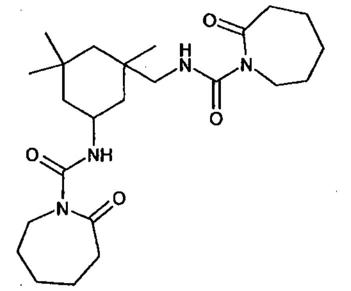 |
| 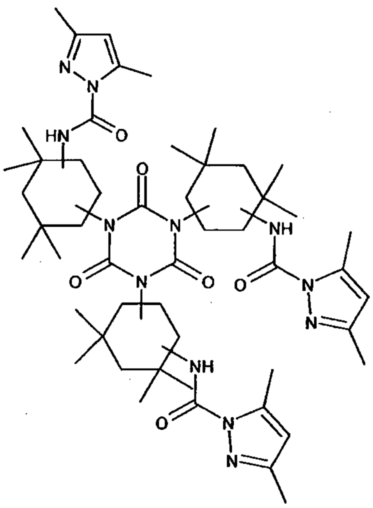 | 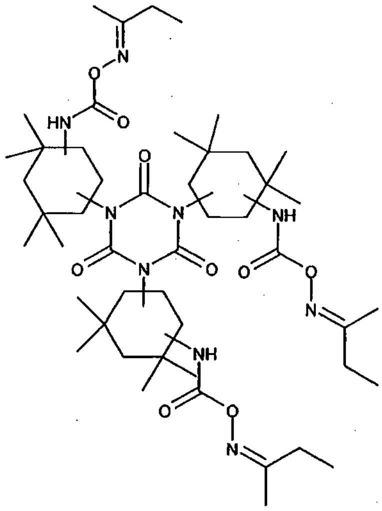 |
| 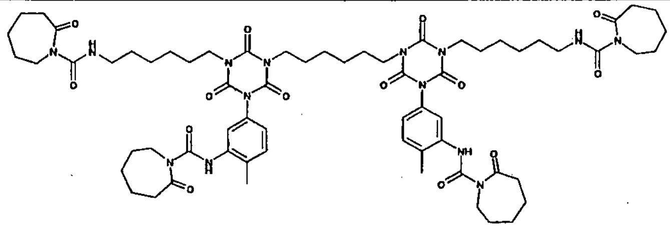 | |

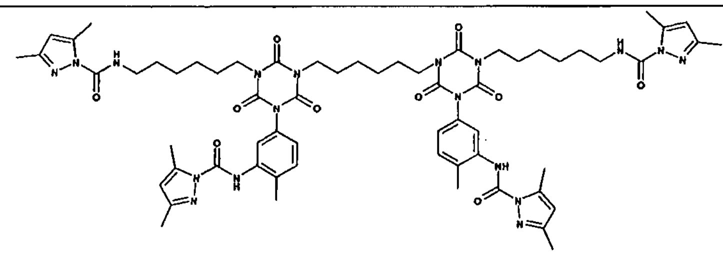

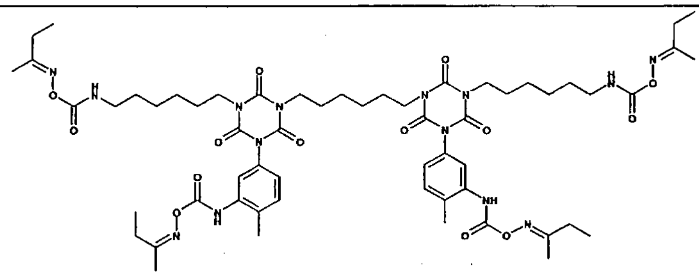

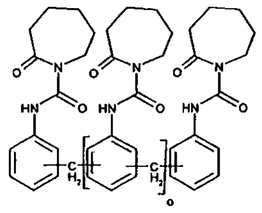

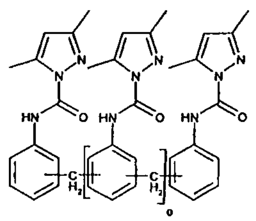

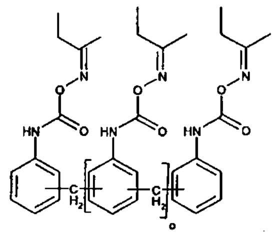

The coating of the present invention further includes an alkaline soluble resin containing at least one monomeric unit including a Lewis base moiety. A Lewis base moiety refers to a functional group which has electrondonor properties. A typical Lewis base moiety is for example a moiety including hydroxyl, thiol, an amine group such as a primary or secondary amine of the formula $-NH_{2-x}R^{d}_{x}$ wherein $R^a$ = alkyl or aryl and x is 0 or 1; a phosphine group of the formula $-PR^{e}_{2-y}Ar_y$ wherein $R^e$ = alkyl and Ar = aryl and y = 0, 1 or 2; groups including O, S, Se and Te such as ethers and ketones; three membered rings with an O, N or S heteroatom such as an epoxide f.e. an oxirane group, an aziridine, thiirane or dioxirane group; an amide group, a thioamide group, an acid group pyridinyl; piperidinyl and an aldehyde group.

Preferably, the monomeric unit is represented by structure III:

$$R\text{-}(L^3)_c\text{-}(X)_n \qquad \text{structure III}$$

wherein

R represents a structural moiety comprising an ethylenically unsatured polymerisable group;

$L^3$ represents a divalent linking group;

X represents a Lewis base moiety;

c is 0 or 1; and

n is an integer comprised between 1 and 9; preferably n is an integer comprised between 1 and 5.

The Lewis base moiety is preferably selected from hydroxyl, thiol, a primary amine or secondary amine of the formula $-NH_{2-x}R^d_x$ wherein $R^d$ = alkyl or aryl and X is 0 or 1; imidazoyl; triazoyl; pyridinyl; piperidinyl; a phosphine of the formula $-PR^e_{2-y}Ar_y$, wherein $R^e$ = alkyl, Ar = aryl and y is 0, 1 or 2; three membered rings with an O, N or S heteroatom such as an epoxide f.e. an oxirane group, an aziridine, thiirane or dioxirane group; an amide group, a thioamide group, an acid group, groups including O, S, Se and Te such as ethers and ketones or an aldehyde group;

In a more preferred embodiment, X independently represents hydroxyl, a primary amine; piperidinyl; an oxirane group; an imidazoyl group; an amide group; an acid group or an aldehyde group.

The structural moiety comprising an ethylenically polymerisable group includes a vinyl, vinyl ether, allyl, acrylyl, methacrylyl, acrylamidyl, methacrylamidyl, maleimidyl, norbornene functionalised maleimidyl or a cycloalkenyl group such as cyclopentenyl or cyclopentadienyl.

Preferably, the structural moiety comprising an ethylenically polymerisable group represents one of the following structures:

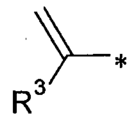 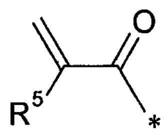 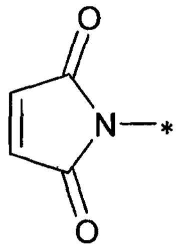

*: R is attached to $-(L^3)_c-(X)_n$ via this bond

wherein $R^3$ and $R^5$ independently represent hydrogen or an alkyl group; preferably $R^3$ and $R^5$ represent a methyl group.

$L^3$ preferably represents an optionally substituted alkylene group - such as a methylene, ethylene, propylene, isopropylene, butylene, tertiary butylene or pentylene group, an alicyclic group - e.g. monocyclic, bicyclic or polycyclic cycloalkylenes such as a cyclobutylene, cyclopentylene, cyclohexylene or adamantylene group, a heterocyclic group, an aralkylene, alkarylene, arylene or heteroarylene group or combinations thereof.

Without being limited thereto, typical examples of the monomeric unit including the Lewis base moiety are given in the Table below.

| | | |
|---|---|---|
| 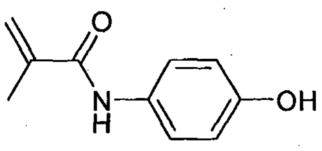 | 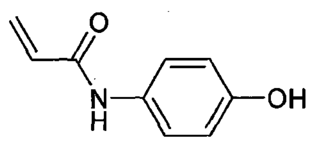 | 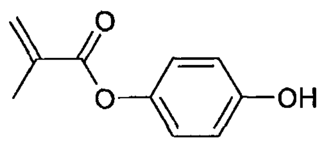 |

| | | |
|---|---|---|
| 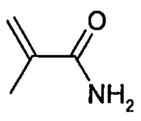 | 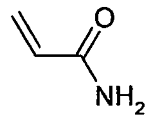 | 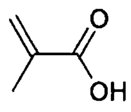 |
| 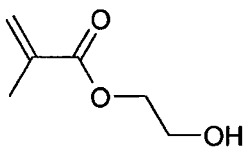 | 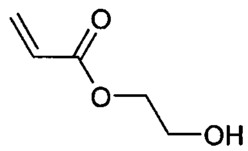 | 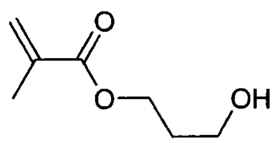 |
| 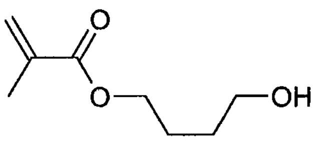 | 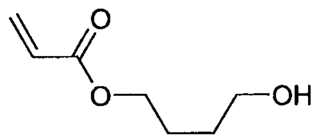 | 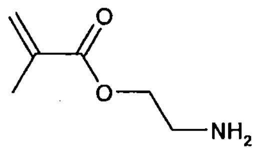 |
| 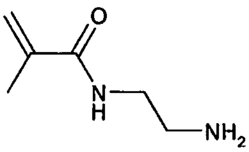 | 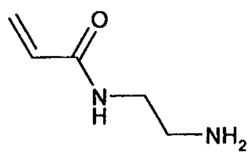 | 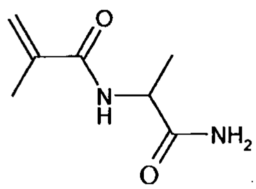 |

| | | |
|---|---|---|
| 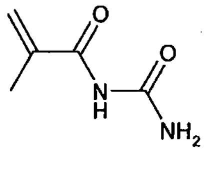 | 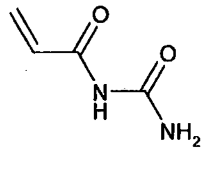 | 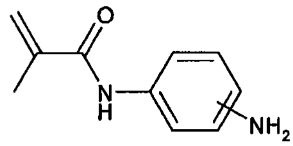 |
| 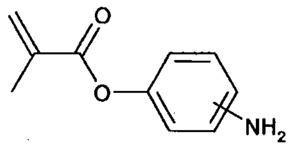 | 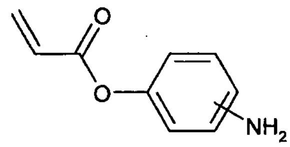 | 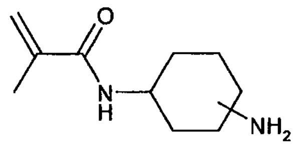 |
| 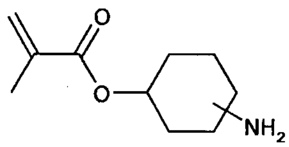 | 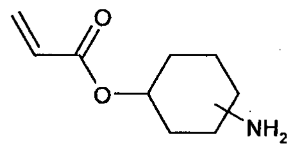 | 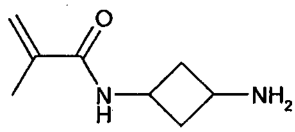 |
| 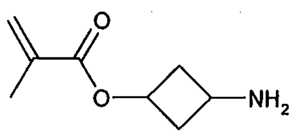 | 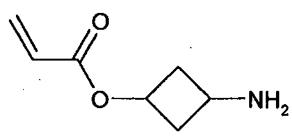 | 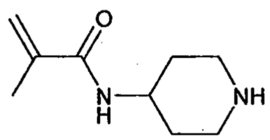 |

| | | |
|---|---|---|
| 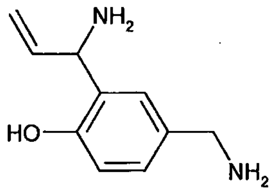 | 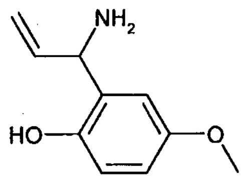 | 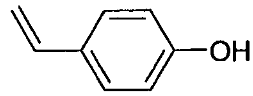 |
| 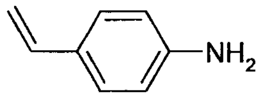 | 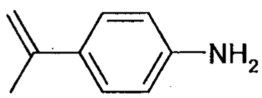 | 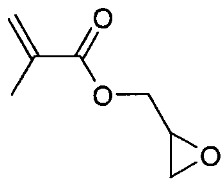 |
| 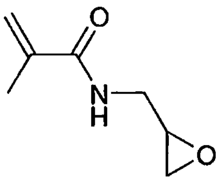 | 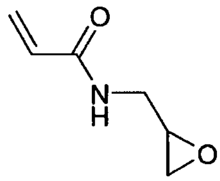 | 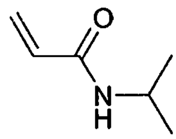 |
| 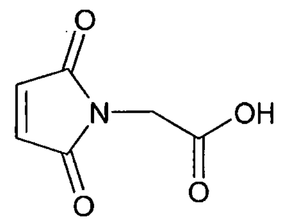 | 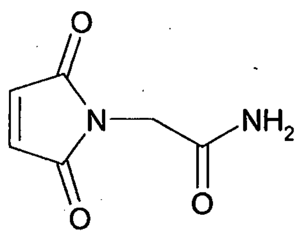 | 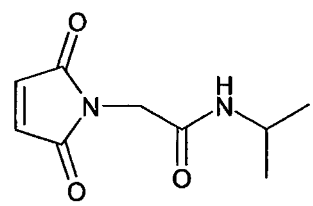 |

| | | |
|---|---|---|
| 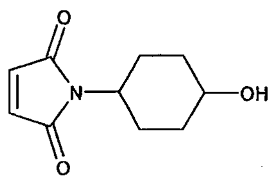 | 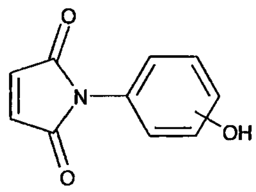 | 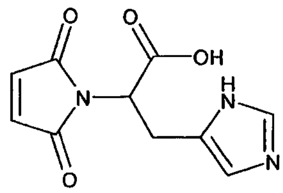 |
| 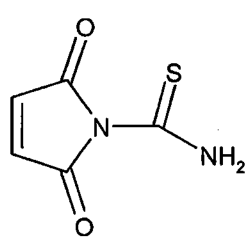 | 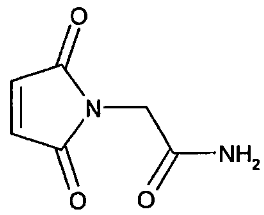 | 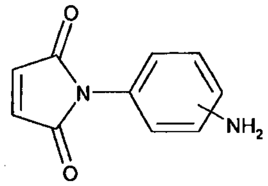 |
| 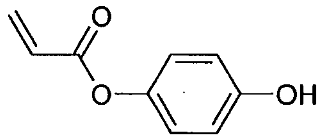 | 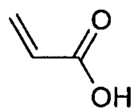 | 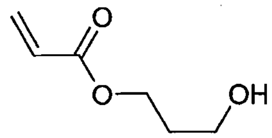 |
| 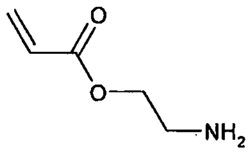 | 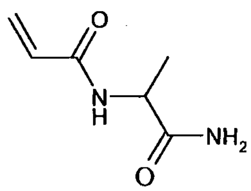 | 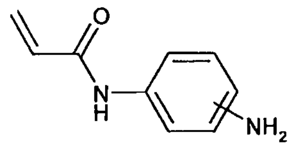 |

| | | |
|---|---|---|
| 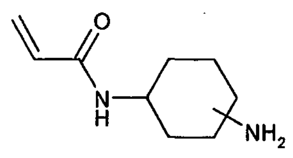 | 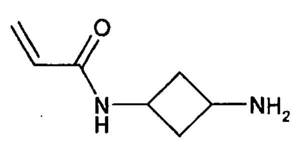 | 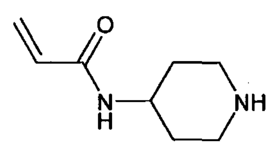 |
| 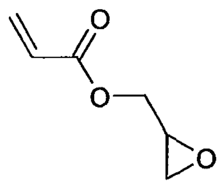 | 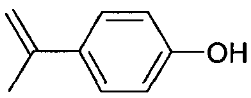 | 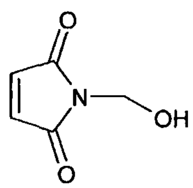 |
| 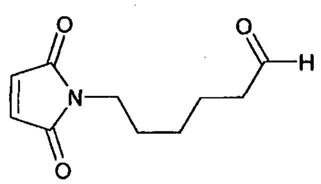 | 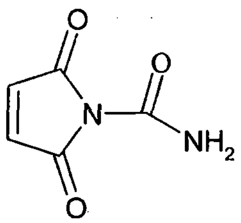 | 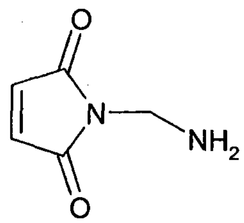 |

In a preferred embodiment, the alkali soluble resin according to the present invention further comprises a monomeric unit including a sulphonamide group. The monomeric unit containing a sulfonamide group is preferably a monomeric unit comprising a sulphonamide group represented by $-NR^j-SO_2-$, $-SO_2-NR^k-$ wherein $R^j$ and $R^k$ each independently represent hydrogen, an optionally substituted alkyl, alkanoyl, alkenyl, alkynyl, cycloalkyl, heterocyclic, aryl, heteroaryl, aralkyl, heteroaralkyl group or combinations thereof.

In a more preferred embodiment the monomeric unit containing a sulfonamide group is derived from the monomer according to structure (IV):

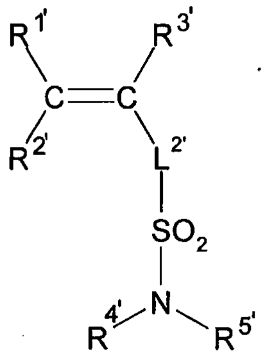

(IV)

wherein

$R^{1'}$, $R^{2'}$ and $R^{3'}$ independently represent hydrogen or an alkyl group such as methyl, ethyl or propyl; preferably $R^{3'}$ is hydrogen or methyl; preferably $R^{1'}$ and $R^{2'}$ are hydrogen;
$L^{2'}$ represents a divalent linking group;
$R^{4'}$ and $R^{5'}$ represent hydrogen, an optionally substituted alkyl group such as methyl, ethyl, propyl, isopropyl,.. , a cycloalkyl such as cyclopentane, cyclohexane, 1,3-dimethylcyclohexane, an alkenyl, alkynyl, alkaryl or aralkyl group, an aryl group such as benzene, naphthalene or antracene, or a heteroaryl aryl group such as furan, thiophene, pyrrole, pyrazole, imidazole, 1,2,3-triazole, 1,2,4-triazole, tetrazole, oxazole, isoxazole, thiazole, isothiazole, thiadiazole, oxadiazole, pyridine, pyridazine, pyrimidine, pyrazine, 1,3,5-triazine, 1,2,4-triazine or 1,2,3-triazine, benzofuran, benzothiophene, indole, indazole, benzoxazole, quinoline, quinazoline, benzimidazole or benztriazole.

Preferably, the linking group $L^{2'}$ represents an alkylene, arylene, heteroarylene, -O-, -CO-, -CO-O-, -O-CO-, -CS-, $-O-(CH_2)_k-$, $-(CH_2)_k-O-$, $-(CH_2)_k-O-CO-$, $-O-CO-(CH_2)_k-$, $-(CH_2)_k-O-CO-(CH_2)_l-$, - $(CH_2)_k-COO-$,$-CO-O-(CH_2)_k-$,$-(CH_2)_k-COO-(CH_2)_1-$, $-(CH_2)_k-NH-$, $-NH-(CH_2)_k-$, - $(CH_2)_k-CONH-$, $-(CH_2)_k-CONH-SO_2-$, $-NH-(CH_2)_k-O-(CH_2)_l-$, $-CO-(CH_2)_k$, $-(CH_2)_k-CO-$, -CO-NH-, -NH-CO-, -NH-CO-O-, -O-CO-NH, $-(CH_2)_k-CO-NH-$,$-NH-CO-(CH_2)_k-$, -NH-CO-NH-, -NH-CS-NH-, or combinations thereof.

The optional substituents may be selected from an alkyl, cycloalkyl, alkenyl or cyclo alkenyl group, an aryl or heteroaryl group, halogen, an alkylamine, an alkylaryl or arylalkyl group, an alkoxy or aryloxy group, a thio alkyl, thio aryl or thio heteroaryl group, a hydroxyl group, -SH, a carboxylic acid group or an alkyl ester thereof, a sulphonic acid group or an alkyl ester thereof, a phosphonic acid group or an alkyl ester thereof, a phosphoric acid group or an alkyl ester thereof, an amino group, a sulphonamide group, an amide group, a nitro group, a nitrile group a halogen or a combination of at least two of these groups, including at least one of these groups which is further substituted by one of these groups.

Further suitable examples of sulfonamide polymers and/or their method of preparation are disclosed in EP 933 682, EP 982 123, EP 1 072 432, WO99/63407, EP 1 400 351, WO07/099047 and EP 2 159 049. Without being limited thereto, typical sulfonamide monomeric units are given below as monomers:

| | |
|---|---|
| 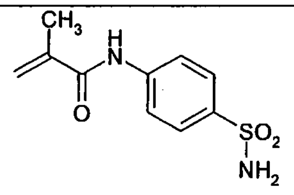 | 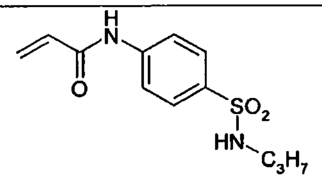 |
| 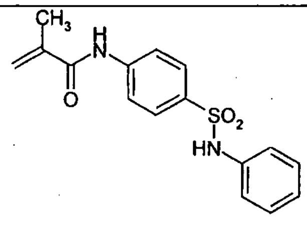 | 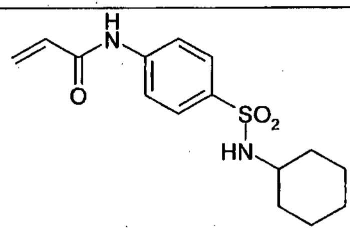 |
| 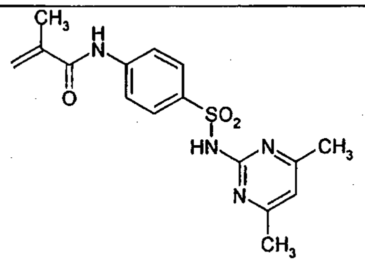 | 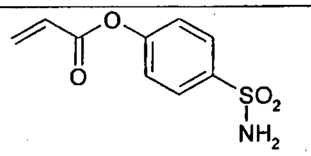 |
| 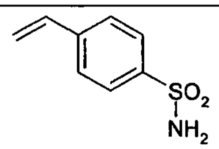 | 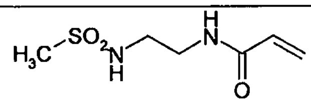 |

| | |
|---|---|
| 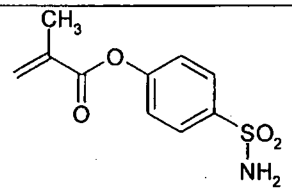 | 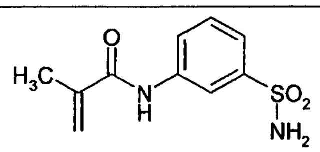 |
| 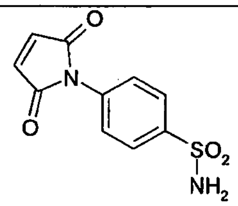 | 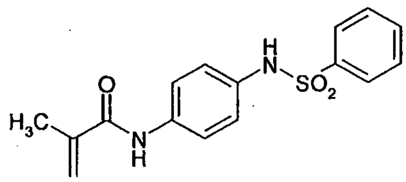 |

The alkali soluble resin according to the present invention may further comprise one or more other monomeric units, preferably selected from an acrylate or methacrylate e.g. an alkyl or aryl (meth)acrylate such as methyl (meth)acrylate, ethyl (meth)acrylate, butyl (meth)acrylate, benzyl (meth)acrylate, 2-phenylethyl (meth)acrylate, hydroxylethyl (meth)acrylate, phenyl (meth)acrylate or N-(4-metylpyridyl)(meth)acrylate; a dialkyl or diaryl (meth)acrylate; (meth)acrylic acid; a (meth)acrylamide e.g. (meth)acrylamide or a N-alkyl or N-aryl (meth)acrylamide such as N-methyl (meth)acrylamide, N-ethyl (meth)acrylamide, N-phenyl (meth)acrylamide, N-benzyl (meth)acrylamide, N-methylol (meth)acrylamide, N-(4-hydroxyphenyl)(meth)acrylamide, dialkyl or diaryl (meth)acrylamide; (meth)acrylonitrile; styrene; a substituted styrene such as 2-, 3- or 4-hydroxy-styrene, 4-benzoic acid-styrene; a vinylpyridine such as 2-vinylpyridine, 3-vinylpyridine, 4-vinylpyridine; a substituted vinylpyridine such as 4-methyl-2-vinylpyridine; vinyl acetate, optionally the copolymerised vinyl acetate monomeric units are at least partially hydrolysed, forming an alcohol group, and/or at least partially reacted by an aldehyde compound such as formaldehyde, salicaldehyde or butyraldehyde, forming an acetal for example a salicaldehyde or butyraldehyde acetal group; vinyl alcohol; vinyl acetal; vinyl butyral; a vinyl ether such as methyl vinyl

ether; vinyl amide; a N-alkyl vinyl amide such as N-methyl vinyl amide, caprolactame, vinyl pyrrolydone; maleic anhydride, a maleimide e.g. maleimide or a N-alkyl or N-aryl maleimide such as N-benzyl maleimide.

In a preferred embodiment, the alkali soluble resin further comprises monomeric units selected from a (meth)acrylamide such as (meth)acrylamide, phenyl (meth)acrylamide, benzyl(meth)acrylamide and methylol (meth)acrylamide; (meth)acrylic acid; styrene; maleic anhydride; a maleimide e.g. maleimide or a N-alkyl or N-aryl maleimide such as N-benzyl maleimide, (meth)acrylates such as methyl (meth)acrylate, phenyl(meth)acrylate, hydroxyethyl (meth)acrylate or benzyl (meth)acrylate. Most preferably, the alkali soluble resin further comprises phenyl (meth)acrylamide or benzyl(meth)acrylamide.

The molar percentage of monomeric units including the functional group including a Lewis base in the alkali soluble resin is preferably between 0.5 and 60 mol %, more preferably between 0.8 and 50 mol % and most preferably between 1 and 45 mol %. In the preferred embodiment where the alkali soluble resin comprises the sulfonamide monomer, the molar percentage of the sulfonamide monomer in the alkali soluble resin is preferably between 25 and 80 mol %, more preferably between 30 and 75 mol % and most preferably between 35 and 70 mol %. The alkali soluble polymer of the present invention has preferably a molecular weight ranging for $M_n$, i.e. number average molecular weight, between 10000 and 500000, more preferably between 15000 and 250000, most preferably between 20000 and 200000, and for $M_w$, i.e. weight average molecular weight, between 10000 and 1000000, more preferably between 50000 and 800000, most preferably between 60000 and 600000. These molecular weights are determined by the method as described in the Examples.

The amount of alkali soluble binder according to the present invention in the coating is preferably above 25 %wt, more preferably above 50 %wt and most preferably above 75% wt relative to the total weight of all ingredients in the coating. Alternatively, the alkali soluble binder according to the present invention in the coating is preferably above 80 %wt, more preferably above 85 %wt and most preferably above 90%wt.

Optionally, the coating may further comprise one or more binders selected from hydrophilic binders such as homopolymers and copolymers of vinyl alcohol, (meth)acrylamide, methylol (meth)acrylamide, (meth)acrylic acid, hydroxyethyl (meth)acrylate, maleic anhydride/vinylmethylether copolymers, copolymers of (meth)acrylic acid or vinylalcohol with styrene sulphonic acid; hydrophobic binders such as phenolic resins (e.g. novolac, resoles or polyvinyl phenols); chemically modified phenolic resins or polymers containing a carboxyl group, a nitrile group or a maleimide group as described in DE 4 007 428, DE 4 027 301 and DE 4 445 820; polymers having an active imide group such as $-SO_2-NH-CO-R^h$, $-SO_2-NH-SO_2-R^h$ or $-CO-NH-SO_2-R^h$ wherein $R^h$ represents an optionally substituted hydrocarbon group such as an optionally substituted alkyl, aryl, alkaryl, aralkyl or heteroaryl group; polymers comprising a N-benzyl-maleimide monomeric unit as described in EP 933 682, EP 894 622 (page 3 line 16 to page 6 line 30), EP 982 123 (page 3 line 56 to page 51 line 5), EP 1 072 432 (page 4 line 21 to page 10 line 29) and WO 99/63407 (page 4 line 13 to page 9 line 37); polymers having an acidic group which can be selected from polycondensates and polymers having free phenolic hydroxyl groups, as obtained, for example, by reacting phenol, resorcinol, a cresol, a xylenol or a trimethylphenol with aldehydes, especially formaldehyde, or ketones; condensates of sulfamoyl- or carbamoyl-substituted aromatics and aldehydes or ketones; polymers of bismethylol-substituted ureas, vinyl ethers, vinyl alcohols, vinyl acetals or vinylamides and polymers of phenylacrylates and copolymers of hydroxy-phenylmaleimides; polymers having units of vinylaromatics, N-aryl(meth)acrylamides or aryl (meth)acrylates containing optionally one or more carboxyl groups, phenolic hydroxyl groups, sulfamoyl groups or carbamoyl groups such as polymers having units of 2-hydroxyphenyl (meth)acrylate, of N-(4-hydroxyphenyl)(meth)acrylamide, of N-(4-sulfamoylphenyl)-(meth)acrylamide, of N-(4-hydroxy-3,5-dimethylbenzyl)-(meth)acrylamide, or 4-hydroxystyrene or of hydroxyphenylmaleimide; vinylaromatics, methyl (meth)acrylate, phenyl(meth)acrylate, benzyl (meth)acrylate, methacrylamide or acrylonitrile.

Preferably, the coating comprises one or more binders selected from homopolymers and copolymers of vinyl alcohol, (meth)acrylamide, methylol (meth)acrylamide, (meth)acrylic acid, hydroxyethyl (meth)acrylate, maleic anhydride/vinylmethylether copolymers, styrenic resins, (meth)acrylonitrile, phenolic resins or sulfonamide binders as described above. Most preferred, the coating includes a sulfonamide binder as defined in detail above.

The coating may comprise one layer or more than one layer. The compound including a blocked isocyanate group and the alkali soluble binder according to the present invention - i.e. the alkali soluble resin including the Lewis base moiety - may be present only in one layer or in more than one layer. Preferably, the coating comprises at least two layers.

In a preferred embodiment, the coating comprises a first layer comprising a compound including a blocked isocyanate group and the alkali soluble binder according to the present invention - further referred to as *the first layer,* and a second layer comprising a phenolic resin located above said first layer - further referred to as *the second layer.* First layer means that the layer is, compared to the second layer, located closer to the lithographic support. The second layer comprising the phenolic resin is an alkaline soluble oleophilic resin. The phenolic resin is preferably a novolac, a resol or a polyvinylphenolic resin; novolac is more preferred. Typical examples of such polymers are described in DE-A-4007428, DE-A-4027301 and DE-A-4445820. Other preferred polymers are phenolic resins wherein the phenyl group or the hydroxy group of the phenolic monomeric unit are chemically modified with an organic substituent as described

in EP 894 622, EP 901 902, EP 933 682, WO99/63407, EP 934 822, EP 1 072 432, US 5,641,608, EP 982 123, WO99/01795, WO04/035310, WO04/035686, WO04/035645, WO04/035687 or EP 1 506 858.

The novolac resin or resol resin may be prepared by polycondensation of at least one member selected from aromatic hydrocarbons such as phenol, o-cresol, p-cresol, m-cresol, 2,5-xylenol, 3,5-xylenol, resorcinol, pyrogallol, bisphenol, bisphenol A, trisphenol, o-ethylphenol, p-etylphenol, propylphenol, n-butylphenol, t-butylphenol, 1-naphtol and 2-naphtol, with at least one aldehyde or ketone selected from aldehydes such as formaldehyde, glyoxal, acetoaldehyde, propionaldehyde, benzaldehyde and furfural and ketones such as acetone, methyl ethyl ketone and methyl isobutyl ketone, in the presence of an acid catalyst. Instead of formaldehyde and acetaldehyde, paraformaldehyde and paraldehyde may, respectively, be used.

The weight average molecular weight, measured by gel permeation chromatography using universal calibration and polystyrene standards, of the novolac resin is preferably from 500 to 150,000 g/mol, more preferably from 1,500 to 50,000 g/mol.

The poly(vinylphenol) resin may also be a polymer of one or more hydroxy-phenyl containing monomers such as hydroxystyrenes or hydroxy-phenyl (meth)acrylates. Examples of such hydroxystyrenes are o-hydroxystyrene, m-hydroxystyrene, p-hydroxystyrene, 2-(o-hydroxyphenyl)propylene, 2-(m-hydroxyphenyl)propylene and 2-(p-hydroxyphenyl)propylene. Such a hydroxystyrene may have a substituent such as chlorine, bromine, iodine, fluorine or a $C_{1-4}$ alkyl group, on its aromatic ring. An example of such hydroxy-phenyl (meth)acrylate is 2-hydroxy-phenyl methacrylate.

The poly(vinylphenol) resin may usually be prepared by polymerizing one or more hydroxy-phenyl containing monomer in the presence of a radical initiator or a cationic polymerization initiator. The poly(vinylphenol) resin may also be prepared by copolymerizing one or more of these hydroxy-phenyl containing monomers with other monomeric compounds such as acrylate monomers, methacrylate monomers, acrylamide monomers, methacrylamide monomers, vinyl monomers, aromatic vinyl monomers or diene monomers.

The weight average molecular weight, measured by gel permeation chromatography using universal calibration and polystyrene standards, of the poly(vinylphenol) resin is preferably from 1.000 to 200,000 g/mol, more preferably from 1,500 to 50,000 g/mol.

The dissolution behavior of the two-layer coating - i.e. the coating comprising the first layer, the second layer and/or optional other layer - in the developer can be finetuned by optional solubility regulating components. More particularly, development accelerators and development inhibitors can be used. These ingredients are preferably added to the second layer.

Development accelerators are compounds which act as dissolution promoters because they are capable of increasing the dissolution rate of the coating, developer resistance means, also called development inhibitors, i.e. one or more ingredients which are capable of delaying the dissolution of the unexposed areas during processing. The dissolution inhibiting effect is preferably reversed by heating, so that the dissolution of the exposed areas is not substantially delayed and a large dissolution differential between exposed and unexposed areas can thereby be obtained. The compounds described in e.g. EP 823 327 and WO 97/39894 are believed to act as dissolution inhibitors due to interaction, e.g. by hydrogen bridge formation, with the alkali-soluble resin(s) in the coating. Inhibitors of this type typically comprise at least one hydrogen bridge forming group such as nitrogen atoms, onium groups, carbonyl (-CO-), sulfinyl (-SO-) or sulfonyl ($-SO_2-$) groups and a large hydrophobic moiety such as one or more aromatic rings. Some of the compounds mentioned below, e.g. infrared dyes such as cyanines and contrast dyes such as quaternized triarylmethane dyes can also act as a dissolution inhibitor.

Preferred examples of inhibitors which delay the penetration of the aqueous alkaline developer into the coating include (i) polymeric materials which are insoluble in or impenetrable by the developer, (ii) bifunctional compounds such as surfactants comprising a polar group and a hydrophobic group such as a long chain hydrocarbon group, a poly- or oligosiloxane and/or a perfluorinated hydrocarbon Group such as Megafac F-177, a perfluorinated surfactant available from Dainippon Ink & Chemicals, Inc., (iii) bifunctional block-copolymers comprising a polar block such as a poly- or oligo(alkylene oxide) and a hydrophobic block such as a long chain hydrocarbon group, a poly- or oligosiloxane and/or a perfluorinated hydrocarbon group such as Tego Glide 410, Tego Wet 265, Tego Protect 5001 or Silikophen P50/X, all commercially available from Tego Chemie, Essen, Germany

The coating of the heat-sensitive printing plate precursors described above preferably also contains an infrared light absorbing dye or pigment which may be present in the first layer, the optional second layer and/or in an optional other layer. Preferred IR absorbing dyes are cyanine dyes, merocyanine dyes, indoaniline dyes, oxonol dyes, pyrilium dyes and squarilium dyes. Examples of suitable IR dyes are described in e.g. EP-As 823327, 978376, 1029667, 1053868, 1093934; WO 97/39894 and 00/29214. A preferred compound is the following cyanine dye:

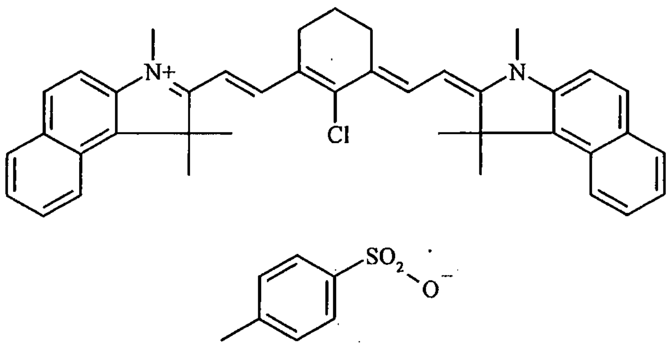

IR-1

The concentration of the IR-dye in the coating is preferably between 0.25 and 15.0 %wt, more preferably between 0.5 and 10.0 %wt, most preferably between 1.0 and 7.5 %wt relative to the coating as a whole.

The coating may further comprise one or more colorant(s) such as dyes or pigments which provide a visible color to the coating and which remain in the coating in the image areas which are not removed during the processing step. Thereby a visible image is formed and examination of the lithographic image on the developed printing plate becomes feasible. Such dyes are often called contrast dyes or indicator dyes. Preferably, the dye has a blue color and an absorption maximum in the wavelength range between 600 nm and 750 nm. Typical examples of such contrast dyes are the amino-substituted tri- or diarylmethane dyes, e.g. crystal violet, methyl violet, victoria pure blue, flexoblau 630, basonylblau 640, auramine and malachite green. Also the dyes which are discussed in depth in EP-A 400,706 are suitable contrast dyes. Dyes which, combined with specific additives, only slightly color the coating but which become intensively colored after exposure, as described in for example WO2006/005688 may also be used as colorants.

Optionally, the coating may further contain additional ingredients. These ingredients may be present in the first layer, or in the optional second or other layers. For example, polymer particles such as matting agents and spacers, surfactants such as perfluoro-surfactants, silicon or titanium dioxide particles, colorants, metal complexing agents are well-known components of lithographic coatings.

To protect the surface of the coating, in particular from mechanical damage, a protective layer may optionally be applied on top of the coating. The protective layer generally comprises at least one water-soluble polymeric binder, such as polyvinyl alcohol, polyvinylpyrrolidone, partially hydrolyzed polyvinyl acetates, gelatin, carbohydrates or hydroxyethylcellulose. The protective layer may contain small amounts, i.e. less then 5 % by weight, of organic solvents. The thickness of the protective layer is not particularly limited but preferably is up to 5.0 μm, more preferably from 0.05 to 3.0 μm, particularly preferably from 0.10 to 1.0 μm.

The coating may further contain other additional layer(s) such as for example an adhesion-improving layer located between the first layer and the support.

The lithographic printing plate used in the present invention comprises a support which has a hydrophilic surface or which is provided with a hydrophilic layer. The support may be a sheet-like material such as a plate or it may be a cylindrical element such as a sleeve which can be slid around a print cylinder of a printing press. Preferably, the support is a metal support such as aluminum or stainless steel. The support can also be a laminate comprising an aluminum foil and a plastic layer, e.g. polyester film.

A particularly preferred lithographic support is an electrochemically grained and anodized aluminum support. The aluminum support has usually a thickness of about 0.1-0.6 mm. However, this thickness can be changed appropriately depending on the size of the printing plate used and/or the size of the plate-setters on which the printing plate precursors are exposed. The aluminium is preferably grained by electrochemical graining, and anodized by means of anodizing techniques employing phosphoric acid or a sulphuric acid/phosphoric acid mixture. Methods of both graining and anodization of aluminum are very well known in the art.

By graining (or roughening) the aluminum support, both the adhesion of the printing image and the wetting characteristics of the non-image areas are improved. By varying the type and/or concentration of the electrolyte and the applied voltage in the graining step, different type of grains can be obtained. The surface roughness is often expressed as arithmetical mean centerline roughness Ra (ISO 4287/1 or DIN 4762) and may vary between 0.05 and 1.5 μm. The aluminum substrate of the current invention has preferably an Ra value below 0.45 μm, more preferably below 0.40 μm, even more preferably below 0.30 μm and most preferably below 0.25 μm. The lower limit of the Ra value is preferably about 0.1 μm. More details concerning the preferred Ra values of the surface of the grained and anodized aluminum support are described in EP 1 356 926.

By anodising the aluminum support, its abrasion resistance and hydrophilic nature are improved. The microstructure as well as the thickness of the $Al_2O_3$ layer are determined by the anodising step, the anodic weight (g/m$^2$ $Al_2O_3$

formed on the aluminium surface) varies between 1 and 8 g/m$^2$. The anodic weight is preferably ≥ 3 g/m$^2$, more preferably ≥ 3.5 g/m$^2$ and most preferably ≥ 4.0 g/m$^2$.

The grained and anodized aluminum support may be subject to a so-called post-anodic treatment to improve the hydrophilic properties of its surface. For example, the aluminum support may be silicated by treating its surface with a sodium silicate solution at elevated temperature, e.g. 95°C. Alternatively, a phosphate treatment may be applied which involves treating the aluminum oxide surface with a phosphate solution that may further contain an inorganic fluoride. Further, the aluminum oxide surface may be rinsed with a citric acid or citrate solution. This treatment may be carried out at room temperature or may be carried out at a slightly elevated temperature of about 30 to 50°C. A further interesting treatment involves rinsing the aluminum oxide surface with a bicarbonate solution. Still further, the aluminum oxide surface may be treated with polyvinylphosphonic acid, polyvinylmethylphosphonic acid, phosphoric acid esters of polyvinyl alcohol, polyvinylsulphonic acid, polyvinylbenzenesulphonic acid, sulphuric acid esters of polyvinyl alcohol, and acetals of polyvinyl alcohols formed by reaction with a sulphonated aliphatic aldehyde.

Another useful post-anodic treatment may be carried out with a solution of polyacrylic acid or a polymer comprising at least 30 mol% of acrylic acid monomeric units, e.g. GLASCOL E15, a polyacrylic acid, commercially available from Ciba Speciality Chemicals.

The support can also be a flexible support, which may be provided with a hydrophilic layer, hereinafter called 'base layer'. The flexible support is e.g. paper, plastic film or aluminum. Preferred examples of plastic film are polyethylene terephthalate film, polyethylene naphthalate film, cellulose acetate film, polystyrene film, polycarbonate film, etc. The plastic film support may be opaque or transparent.

The base layer is preferably a cross-linked hydrophilic layer obtained from a hydrophilic binder cross-linked with a hardening agent such as formaldehyde, glyoxal, polyisocyanate or a hydrolyzed tetra-alkylorthosilicate. The latter is particularly preferred. The thickness of the hydrophilic base layer may vary in the range of 0.2 to 25 μm and is preferably 1 to 10 μm. More details of preferred embodiments of the base layer can be found in e.g. EP-A 1 025 992.

Any coating method can be used for applying two or more coating solutions to the hydrophilic surface of the support. The multi-layer coating can be applied by coating/drying each layer consecutively or by the simultaneous coating of several coating solutions at once. In the drying step, the volatile solvents are removed from the coating until the coating is self-supporting and dry to the touch. However it is not necessary (and may not even be possible) to remove all the solvent in the drying step. Indeed the residual solvent content may be regarded as an additional composition variable by means of which the composition may be optimized. Drying is typically carried out by blowing hot air onto the coating, typically at a temperature of at least 70°C, suitably 80-150°C and especially 90-140°C. Also infrared lamps can be used. The drying time may typically be 15-600 seconds.

Between coating and drying, or after the drying step, a heat treatment and subsequent cooling may provide additional benefits, as described in WO99/21715, EP-A 1074386, EP-A 1074889, WO00/29214, and WO/04030923, WO/04030924, WO/04030925.

The heat-sensitive plate precursor can be image-wise exposed directly with heat, e.g. by means of a thermal head, or indirectly by infrared light, preferably near infrared light. The infrared light is preferably converted into heat by an IR light absorbing compound as discussed above. The printing plate precursor is positive working and relies on heat-induced solubilization of the binder of the present invention. The binder is preferably a polymer that is soluble in an aqueous developer, more preferably an aqueous alkaline developing solution with a pH between 7.5 and 14.

The printing plate precursor can be exposed to infrared light by means of e.g. LEDs or a laser. Most preferably, the light used for the exposure is a laser emitting near infrared light having a wavelength in the range from about 750 to about 1500 nm, more preferably 750 to 1100 nm, such as a semiconductor laser diode, a Nd:YAG or a Nd:YLF laser. The required laser power depends on the sensitivity of the plate precursor, the pixel dwell time of the laser beam, which is determined by the spot diameter (typical value of modern plate-setters at 1/e$^2$ of maximum intensity : 5-25 μm), the scan speed and the resolution of the exposure apparatus (i.e. the number of addressable pixels per unit of linear distance, often expressed in dots per inch or dpi; typical value : 1000-4000 dpi).

Two types of laser-exposure apparatuses are commonly used: internal (ITD) and external drum (XTD) plate-setters. ITD plate-setters for thermal plates are typically characterized by a very high scan speed up to 500 m/sec and may require a laser power of several Watts. XTD platesetters for thermal plates having a typical laser power from about 200 mW to about 1 W operate at a lower scan speed, e.g. from 0.1 to 10 m/sec. An XTD platesetter equipped with one or more laserdiodes emitting in the wavelength range between 750 and 850 nm is an especially preferred embodiment for the method of the present invention.

The known plate-setters can be used as an off-press exposure apparatus, which offers the benefit of reduced press downtime. XTD plate-setter configurations can also be used for on-press exposure, offering the benefit of immediate registration in a multi-color press. More technical details of on-press exposure apparatuses are described in e.g. US 5,174,205 and US 5,163,368.

Preferred lithographic printing plate precursors according to the present invention produce a useful lithographic image upon image-wise exposure with IR-light having an energy density, measured at the surface of said precursor, of

200 mJ/cm$^2$ or less, more preferably of 180 mJ/cm$^2$ or less, most preferably of 160 mJ/cm$^2$ or less. With a useful lithographic image on the printing plate, 2 % dots (at 200 lpi) are perfectly visible on at least 1000 prints on paper.

The printing plate precursor, after exposure, is preferably developed off-press by means of a suitable processing liquid. In the development step, the exposed areas of the image-recording layer are at least partially removed without essentially removing the non-exposed areas, i.e. without affecting the exposed areas to an extent that renders the ink-acceptance of the exposed areas unacceptable. The processing liquid can be applied to the plate e.g. by rubbing with an impregnated pad, by dipping, immersing, (spin-)coating, spraying, pouring-on, either by hand or in an automatic processing apparatus. The treatment with a processing liquid may be combined with mechanical rubbing, e.g. by a rotating brush. The developed plate precursor can, if required, be post-treated with rinse water, a suitable correcting agent or preservative as known in the art. During the development step, any water-soluble protective layer present is preferably also removed. The development is preferably carried out at temperatures of from 20 to 40 °C in automated processing units as customary in the art. More details concerning the development step can be found in for example EP 1 614 538, EP 1 614 539, EP 1 614 540 and WO/2004/071767.

The developing solution preferably contains a buffer such as for example a silicate-based buffer or a phosphate buffer. The concentration of the buffer in the developer preferably ranges bewteen 3 to 14 %wt. Silicate-based developers which have a ratio of silicon dioxide to alkali metal oxide of at least 1 are advantageous because they ensure that the alumina layer (if present) of the substrate is not damaged. Preferred alkali metal oxides include $Na_2O$ and $K_2O$, and mixtures thereof. A particularly preferred silicate-based developer solution is a developer solution comprising sodium or potassium metasilicate, i.e. a silicate where the ratio of silicon dioxide to alkali metal oxide is 1.

The developing solution may optionally contain further components as known in the art: other buffer substances, chelating agents, surfactants, complexing agents, complexes, inorganic salts, inorganic alkaline agents, organic alkaline agents, antifoaming agents, organic solvents in small amounts i.e. preferably less than 10%wt and more preferably less than 5%wt, non-reducing sugars, glycosides, dyes and/or hydrotropic agents. These components may be used alone or in combination.

To ensure a stable processing with the developer solution for a prolonged time, it is particularly important to control the concentration of the ingredients in the developer. Therefore a replenishing solution, hereinafter also referred to as replenisher, is often added to the developing solution. More than one replenishing solution containing different ingredients and/or different amounts of the ingredients may be added to the developing solution. Alkali metal silicate solutions having alkali metal contents of from 0.6 to 2.0 mol/l can suitably be used. These solutions may have the same silica/alkali metal oxide ratio as the developer (generally, however, it is lower) and likewise optionally contain further additives. It is advantageous that the (co)polymer of the present invention is present in the replenisher(s); preferably at a concentration of at least 0.5 g/l, more preferably in a concentration ranging between 1 and 50 g/l most preferably between 2 and 30 g/l.

The replenishing solution has preferably a pH value of at least 10, more preferably of at least 11, most preferably of at least 12.

The development step may be followed by a rinsing step and/or a gumming step. A suitable gum solution which can be used is described in for example EP-A 1 342 568 and WO 2005/111727.

To increase the resistance to chemicals and/or printing liquids of the finished printing plate and to extend its presslife capability (run length), the plate coating is preferably briefly heated to elevated temperatures ("baking"). The plate can be dried before baking or is dried during the baking process itself. During the baking step, the plate can be heated at a temperature between 100°C and 300°C for a period of 15 seconds to 5 minutes. In a preferred embodiment, the baking temperature does not exceed 300°C during the baking period. Baking can be done in conventional hot air ovens or by irradiation with lamps emitting in the infrared or ultraviolet spectrum, as e.g. described in EP 1 588 220 and EP 1 916 101. Both so-called static and dynamic baking ovens can be used. As a result of this baking step, the resistance of the printing plate to plate cleaners, correction agents and UV-curable printing inks increases. Also, the abrasion or mechanical resistance of the baked plate is improved. Such a thermal posttreatment is known in the art and is described, inter alia, in DE 1 447 963, GB 1 154 749 and EP 1 506 854.

According to the present invention there is also provided a method for making a positive-working lithographic printing plate comprising the steps of imagewise exposing the heat-sensitive lithographic printing plate precursor according to the present invention to heat and/or infrared light, followed by developing the imagewise exposed precursor with an aqueous alkaline developer so that the exposed areas are dissolved. The obtained precursor is preferably baked. Baking may be done by keeping the plate at a temperature between 200°C and 300°C during a period between 30 seconds and 2 minutes. The baking step may also be carried out as described in the previous paragraph.

The printing plate thus obtained can be used for conventional, so-called wet offset printing, in which ink and an aqueous dampening liquid is supplied to the plate. Another suitable printing method uses a so-called single-fluid ink without a dampening liquid. Suitable single-fluid inks have been described in US 4,045,232; US 4,981,517 and US 6,140,392. In a most preferred embodiment, the single-fluid ink comprises an ink phase, also called the hydrophobic or oleophilic phase, and a polyol phase as described in WO 00/32705.

EXAMPLES

## I. <u>Synthesis of the alkali soluble binders.</u>

Synthesis of N-p-hydroxyphenyl methacrylamide.

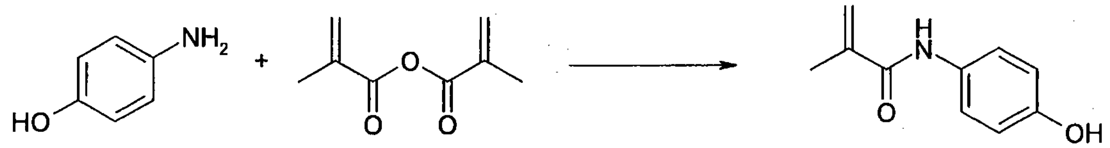

100 g (0.92 mol) of 4-aminophenol (commercially available) and 84.8 g of sodium hydrogenocarbonate ($NaHCO_3$, 1.01 mol) were dissolved in acetone at T < 15 °C in the presence of 4-dimethyl-aminopyridine as a catalyst. 159.94 g (1.01 mol) of methacrylic acid anhydride were added dropwise at 0 °C and stirred for 0.5 hours. The remaining salt was filtrated off before solvent evaporation under reduced pressure. The product was rinsed twice with methyl-t-butyl ether. Pure Monomer-1 was recovered with a yield of 81.7 %. Purity was determined by thin-layer chromatography.

Synthesis of phenyl acrylamide.

Phenyl acrylamide was synthesized via acylation of aniline followed by the β-elimination of the 3-chloropropionyl amide intermediate product (intermediate 1).

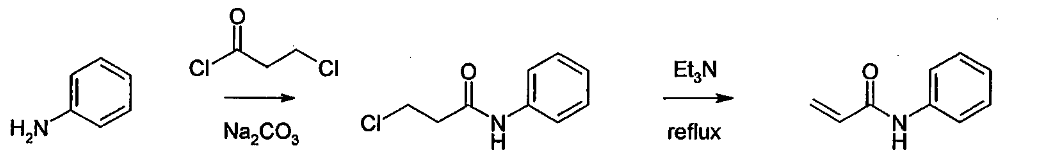


**intermediate 1** **Phenyl acrylamide**

Aniline (0.1 mol) was dissolved in ethyl acetate (80 ml). $Na_2CO_3$ (12.72 g, 0.12 mol) dissolved in water (100 ml) was added to the reaction mixture and cooled to 0°C. 3-chloropropionyl chloride (13.86 g, 0.11 mol) dissolved in 20 ml ethyl acetate was added over 20 minutes under constant stirring. The temperature was kept at 0°C. The reaction was allowed to continue for an additional hour at room temperature. After filtration, the organic phase was isolated, washed twice with water and dried over $MgSO_4$. The solvent was evaporated under reduced pressure and recrystallization from MeOH/water yielded intermediate 1 (yield = 98%, mp = 118-120°C).
Intermediate 1 (80 mmol) and triethylamine (160 mmol) were dissolved in ethyl acetate (170 ml). The mixture was refluxed for 24 hours. The reaction mixture was allowed to cool down to room temperature. The salts were removed by filtration. The organic fraction was extracted twice with 80 ml 3 N HCl, dried over $Na_2SO_4$, and evaporated under reduced pressure. Yield = 89.6 %, mp = 106-108 °C.

Synthesis of the alkali soluble binders.

Polymers 1, 2 and 3 were prepared according to the procedure below. The monomer composition, the initiation temperature, the time in minutes for the post-initiation are given in Table A and the molecular weights (GPC) are given in Table B. The molecular weight of the copolymers ($M_n$, $M_w$, $M_w/M_n$) was analyzed by size exclusion chromatography (SEC) by using dimethyl acetamide/0.21% LiCl/0.63% HOAc as eluent and 3 mixed-B columns that were calibrated against linear polystyrene standards.
In a 250 ml reactor, the monomers A, B and/or C (70 mmol in total and the ratio's are given in Table A) were added to 35.4 g of gamma-butyrolactone (GBL) and the mixture was heated to 140°C, while stirring at 200 rpm. Upon complete dissolution of the monomer mixture, the reaction mixture was allowed to cool down to the initiation temperature as indicated in Table 4. 80 μL of Trigonox™ DC-50 (0.14 mmol, commercially available from AKZO NOBEL) was added at once, immediately followed by the addition of 1121 μL of a 25 wt-% solution of Trigonox™-141 (0.7 mmol, commercially available from AKZO NOBEL) in GBL. The temperature was increased or decreased to the post-initiation temperature. 0.7 mmol of V-601™ (commercially available at Wako Fine Chemical Co.) in 1-methoxy-2-propanol were added at 105 or 140 °C. The polymerization was allowed to continue for 240 minutes. The reaction mixture was diluted with 19.0 mL of 1-methoxy-2-propanol. The reaction mixture was allowed to cool down to room temperature. The solution was used

directly for the preparation of the coating solutions without further purification.

The presence of residual monomers was analyzed by using thin layer chromatography in comparison with original samples of the different monomers. Partisil KC18F™ plates (commercially available from Whatman) and MeOH/0.5 M NaCl 60/40 were used as stationary and mobile phase, respectively. In none of the samples, residual monomers were detected. Thus, the monomers composition in the feed is equal to the monomers composition in the backbone of the polymer.

Table A: Monomers composition and experimental data.

| | Monomer A* | Monomer B* | Monomer C* | Initiation/ post-initiation temperature |
|---|---|---|---|---|
| **Polymer 1** | 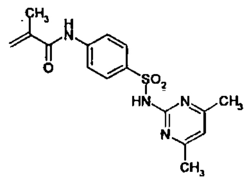 | 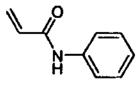 | - | 105°C/130°C |
| | 65 mol-% | 35 mol-% | - | |
| **Polymer 2** | 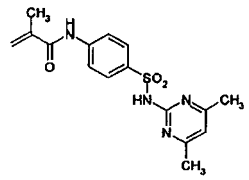 | 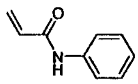 | 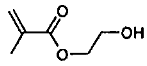 | 110°C/105°C |
| | 46 mol-% | 24 mol-% | 30 mol-% | |
| **Polymer 3.** | 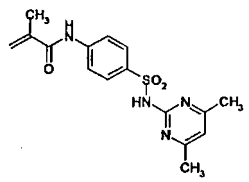 | 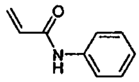 | 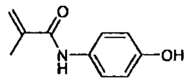 | 100°C/105°C |
| | 62 mol-% | 33 mol-% | 5 mol-% | |

*: monomer A was synthesized by a method described in Hofmann et al., Makromoleculare Chemie 1976, 177, 1791-1813; monomer B and monomer C (phenyl acrylamide) were synthesized as described above and monomer C(hydroxyethyl acrylate) is commercially available from Sigma Aldrich.

The molecular weight of the copolymers ($M_n$, $M_w$, $M_w/M_n$) was analyzed by size exclusion chromatography (SEC) by using dimethyl acetamide /0.21% LiCl /0.63% HOAc as an eluent and 3 mixed-B columns that were calibrated against linear polystyrene standards. The analytical results are given in Table B.

Table B: Molecular weight of the polymers (GPC).

| | $M_n$ | $M_w$ | $M_w/M_n$ |
|---|---|---|---|
| Polymer 1 | 40,740 | 129,760 | 3.18 |
| Polymer 2 | 32,800 | 141,400 | 4.31 |
| Polymer 3 | 39,000 | 110,200 | 2.83 |

**II. Preparation of the lithographic support S-01.**

A 0.3 mm thick aluminium foil was degreased by spraying with an aqueous solution containing 34 g/l NaOH at 70°C for 6 seconds and rinsed with demineralised water for 3.6 seconds. The foil was then electrochemically grained during 8 seconds using an alternating current in an aqueous solution containing 15 g/l HCl, 15 g/l $SO_4^{2-}$ ions and 5 g/l $Al^{3+}$ ions at a temperature of 37°C and a current density of about 100 A/dm$^2$ (charge density of about 800 C/dm$^2$). Afterwards, the aluminium foil was desmutted by etching with an aqueous solution containing 145 g/l of sulfuric acid at 80°C for 5 seconds and rinsed with demineralised water for 4 seconds. The foil was subsequently subjected to anodic

oxidation during 10 seconds in an aqueous solution containing 145 g/l of sulfuric acid at a temperature of 57°C and a current density of 33A/dm$^2$ (charge density of 330 C/dm$^2$), then washed with demineralised water for 7 seconds and post-treated for 4 seconds (by spray) with a solution containing 2.2 g/l polyvinylphosphonic acid at 70°C, rinsed with demineralised water for 3.5 seconds and dried at 120°C for 7 seconds.

The support thus obtained was characterised by a surface roughness Ra of 0.35-0.4μm (measured with interferometer NT1100) and an anodic weight of 4.0 g/m$^2$.

**III. Test samples including blocked isocyanates compounds**

1. Blocked isocyanates compounds.

The blocked isocyanates compounds are commercially available form BAXENDEN CHEMICALS LTD. The type, chemical structure, composition and deblocking temperature are given in Table C.

Table C: Structure of the blocked isocyanates crosslinkers.

| Crosslinker | Structure | Deblocking temperature (4) |
|---|---|---|
| Crosslinker 1 (1) | 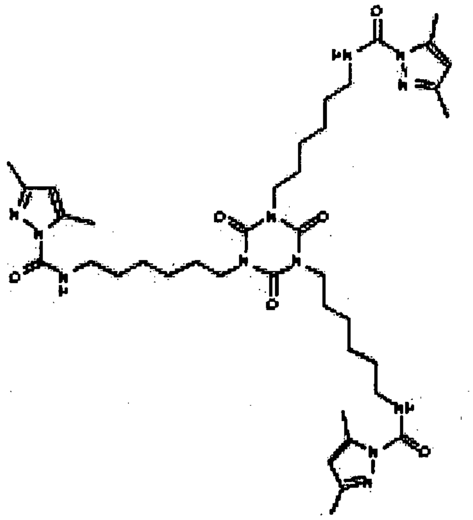 | 120°C |
| Crosslinker 2 (2) | 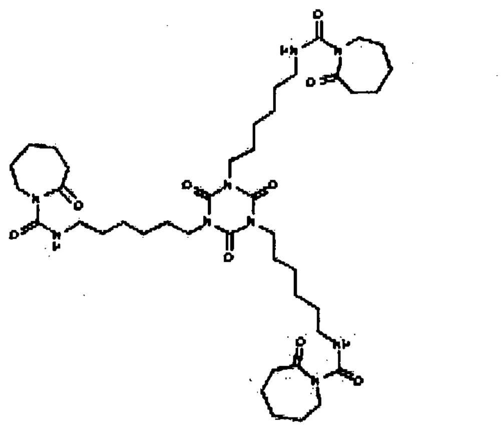 | 180°C |

(continued)

| Crosslinker | Structure | Deblocking temperature (4) |
|---|---|---|
| Crosslinker 3 (3) | 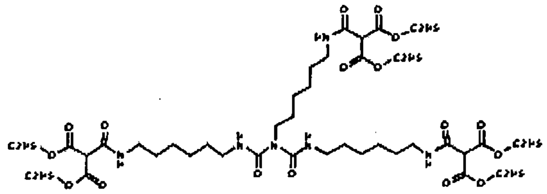 | 90°C |
| (1) 3,5-dimethylpyrazole blocked hexamethylene diisocyanate trimer; TRIXENE BI 7982 (type); solid content= 68-72 wt% and solvent = propylene glycol monomethyl ether;<br>(2) Caprolactam blocked hexamethylene diisocyanate trimer; TRIXENE BI 7981 (type); solid content = 63-67 wt% and solvent = methoxypropyl acetate;<br>(3) Diethylmalonate blocked hexamethylene diisocyanate biuret; TRIXENE BI 7963 (type); solid content = 68-72 wt% and Solvent = Propylene Glycol Methyl Ether / diethyl malonate;<br>(4) Deblocking temperature provided by the supplier. An alternative method for measuring the deblocking temperature of the blocked isocyanate compounds is given below. | | |

**The determination of the deblocking temperature.**

FTIR-analysis of the crosslinker-1 and crosslinker-2 was performed on a Diglab™ FTS3000 FT-IR spectroscope equipped with a UMA500-microscope and a Mettler™ FP82 hotstage. The hotstage was calibrated against benzophenone (melting point = 48,1°C), benzoic acid (melting point = 122,3°C), and saccharine (melting point = 228.8°C). Error in the determination of the temperature is +/- 2°C. 1 ml of the crosslinker solution (30-35 wt% active material in 2-methoxy-1-propanol) was spin-coated on the non-polished backside of Si-wafer (1 second @ 2000rpm + 60 seconds @ 4000rpm). Prior to the measurements, the intensity of the most absorbing band (here the C=O groups) of the spun film was measured at 23°C: the intensity should be superior to 1 absorbance unit and inferior to 2 absorbance units, which allows quantitative measurements (range of application of the Beer-Lambert law). This criterion should be respected for any crosslinkers studied and their film preparation adapted (spun solution concentration and spinning conditions). The wafer was then placed onto the Mettler FP82 hotstage and heated from 30 to 250°C with a heating rate of 10°C /min under ambient air flow. FTIR-spectra were recorded every 5 °C while making sure that the temperature was constant during the measurement (45 scans/spectrum). Isocyanate release in function of the temperature was monitored by the formation of the NCO peak at 2270 cm-1 (baseline 2373-2156cm-1). The peak intensities were normalized to the -CH2- absorbance peak (2930 cm-1, baseline 3057-2775 $cm^{-1}$) that was taken as a reference. This normalization procedure allowed consistent measurements independently of the layer thickness. The extrapolated onset temperature is the point of intersection of the tangent drawn at the point of greatest slope with the extrapolated baseline (here the x axis) (see Figure 1).

Figure 1: Determination of the deblocking temperature of crosslinker-1 and 2 by Fourier-Transform Infra-Red spectroscopy (FT-IR).

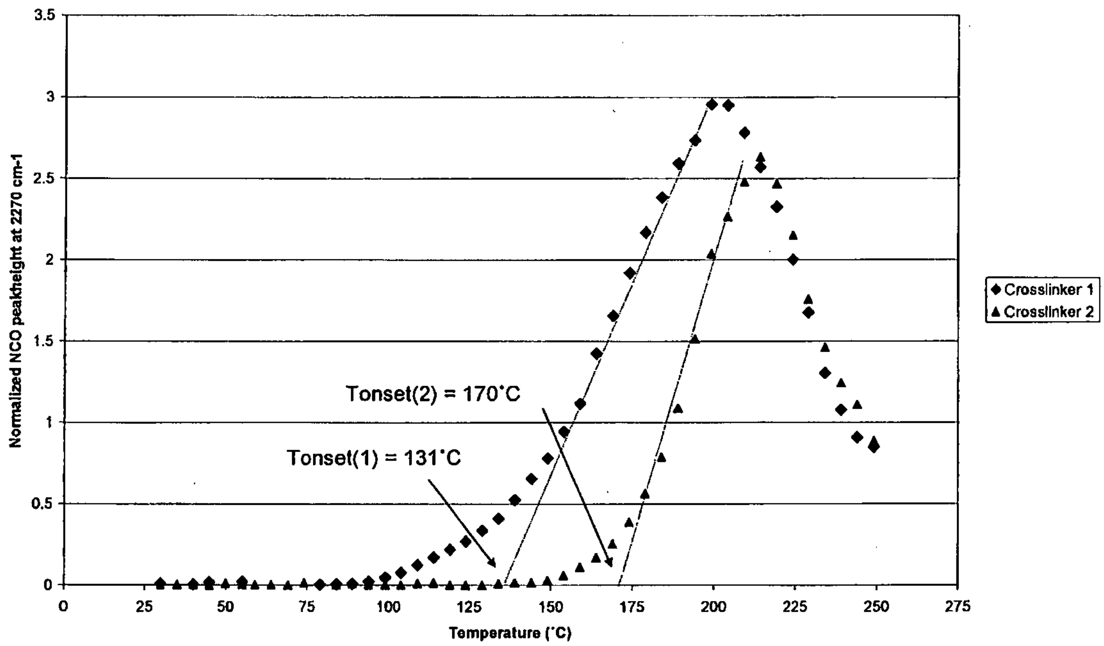


From Figure 1, it can be concluded that deprotection of the reactive isocyanate function occurs at 131°C and 170°C for crosslinker-1 and crosslinker-2 respectively. Those values corroborate the specification data at +/- 10°C. The maximum of the NCO peak intensity is observed at T = 199°C and at T = 214°C for crosslinker-1 and crosslinker-2 respectively, indicating that the highest reactivity is observed at T ≥ 199°C and T ≥ 214°C for crosslinker-1 and crosslinker-2 respectively. The decrease of the normalized NCO peak intensity observed for T > 199°C and T > 214°C for crosslinker-1 and crosslinker-2 respectively, corresponds to the reaction of the isocyanate groups with moisture. In the printing plate of the present invention, the deblocked isocyanate groups react with the functionalized binder (instead of moisture).

2. <u>Preparation of the test samples TS-01 to TS-09.</u>

The test samples were TS-01 to TS-09 were produced by applying a coating solution onto the above described lithographic support S-01. The coating solution contains the ingredients, as defined in Table C, dissolved in a mixture of the following solvents: 57% by volume of tetrahydrofuran, 33% by volume of Dowanol PM™ (1-methoxy-2-propanol, commercially available from DOW CHEMICAL Company) and 10% by volume of gamma-butyrolactone. The coating solution was applied at a wet coating thickness of 20 μm and then dried in a static oven working at 135°C for 3 minutes. The maximum temperature of the back-side of the test samples, during the drying step, was 127°C (measured with THERMAX™, a surface temperature indicating strip, commercially available from TMC - temperature range: 88-138°C). The dry coating weight amount in g/m$^2$ of each of the ingredients is indicated in Table D.

Table D: Composition and dry coating weight of the test samples.

| Test sample | polymer (1) | polymer g/m$^2$ | Crystal violet (2) g/m$^2$ | Tegoglide 410 (3) g/m$^2$ | Blocked isocyanate crosslinker (4) g/m$^2$ | |
|---|---|---|---|---|---|---|
| | | | | | 1 | 2 |
| TS-01, Comp. | Polymer 1 | 0.660 | 0.01 | 0.001 | - | - |
| TS-02, Comp. | Polymer 1 | 0.660 | 0.01 | 0.001 | 0.06 | - |

(continued)

| Test sample | polymer (1) | polymer g/m² | Crystal violet (2) g/m² | Tegoglide 410 (3) g/m² | Blocked isocyanate crosslinker (4) g/m² | |
|---|---|---|---|---|---|---|
| | | | | | 1 | 2 |
| TS-03, Comp. | Polymer 1 | 0.660 | 0.01 | 0.001 | - | 0.06 |
| TS-04, Comp. | Polymer 2 | 0.660 | 0.01 | 0.001 | - | - |
| TS-05, Comp. | Polymer 3 | 0.660 | 0.01 | 0.001 | - | - |
| TS-06, Inv. | Polymer 2 | 0.660 | 0.01 | 0.001 | 0.06 | - |
| TS-07, Inv. | Polymer 2 | 0.660 | 0.01 | 0.001 | - | 0.06 |
| TS-08, Inv. | Polymer 3 | 0.660 | 0.01 | 0.001 | 0.06 | - |
| TS-09, Inv. | Polymer 3 | 0.660 | 0.01 | 0.001 | - | 0.06 |

(1) See Table A above;
(2) Crystal Violet, commercially available from CIBA-GEIGY;
(3) TEGOGLIDE 410 is a copolymer of polysiloxane and poly(alkylene oxide), commercially available from TEGO CHEMIE SERVICE GmbH;
(4) See table C above.

3. <u>Chemical resistance test.</u>

The chemical resistance of the test samples was evaluated as follows. Part of each of the test samples TS-01 to TS-09 was put through a dynamic baking oven (Top Line OG15 dynamic oven from Systemtechnik Haase GmbH) working at 270°C and 1.1 m/min. The maximum temperature of the back-side of the test samples, during the baking step, was 254°C (measured with testoterm™, a thermometer strip, commercially available from Testo - temperature range: 204-260°C). This resulted in a "baked test sample".

Subsequently a drop of 40 µl of RevivaPlate™ (plate cleaner commercially available from Agfa Graphics N.V.) was applied onto the surface of the coating of the baked test sample and was left there for 1 minute. Finally, this drop was wiped off with a cotton pad and the test sample was rinsed with tap water and left to dry.

The resulting relative coating loss (RCL) was measured with a GretagMacBeth D19c™ densitometer (commercially available from Gretag-Macbeth AG) and defined as follows:

Relative Coating Loss (RCL, %) = [1 - (optical density after 1 minute of contact with RevivaPlate™*)/optical density without contact with RevivaPlate™*] x 100.

*: plate cleaner commercially available from Agfa Graphics N.V.

The results of the 1 minute contact with RevivaPlate™ for the baked test samples are given in Table E.

Table E: Results of the chemical resistance test.

| Test samples | RCL* (%) |
|---|---|
| TS-01, comp. | 90 |
| TS-02, comp. | 94 |

(continued)

| Test samples | RCL* (%) |
|---|---|
| TS-03, comp. | 95 |
| TS-04, comp. | 85 |
| TS-05, comp. | 74 |
| TS-06, inv. | 9 |
| TS-07, inv. | 12 |
| TS-08, inv. | 37 |
| TS-09, inv. | 44 |
| * Relative Coating Loss: see above. | |

The results show that the test samples comprising a blocked isocyanate compound and the binder according to the present invention (TS-06 to TS-09), provide a substantive improvement of the chemical resistance of the coating.

4. Abrasion resistance test.

The mechanical resistance of the printing plates was measured by the abrasion resistance test. The abrasion resistance of the baked test samples TS-01, TS-02, TS-04 (Comparative Examples), and TS-06 (Inventive Example) was tested as follows.

Six round rubber (hardness 75 Shore A) stamps with a diameter of 15 mm were simultaneously rotated in contact with the test sample with a load of 9.5 N each and while the coating is wet (4 ml demineralised water per contact area). Fifty test cycles were applied to each test sample, each test cycle consists of 25 seconds of contact at a rotational speed of 100 rpm and 1 second of non-contact in order to allow the demineralised water to recover the contact area.

In this way, five samples of each test sample TS-01, TS-02, TS-04 and TS-06 were tested, resulting in a total of 30 contact areas subjected to abrasion per test sample.

A quantitative assessement of the resulting wear of the contact areas of the test samples was performed as follows. Each of the 30 contact areas subjected to abrasion was scanned in with a HP Scanjet 5590P (commercially available from HP) both before and after rotational contact abrasion. The automatic exposure and colour adjusment parameters setting was switched off and instead the following exposure parameter values were set manually : "0", "-69" and "0" for respectively the high lights, the shadows and the midtones. The resulting images were converted to 8 bit grey-scale images (grey-level values from 0 to 255, whereby 0 represents "black" and 255 represents "white"). The coating wear was calculated from the measured change in coating grey-level value:

Relative coating wear (RCW, %) = [(grey-level value after rotational abrasion/grey-level value before rotational abrasion)-1] X 100.

The results for baked test samples TS-01, TS-02, TS-04 and TS-06 are given in Table F.

Table F: Results of the abrasion resistance test.

| Test samples | RCW* (%) |
|---|---|
| TS-01, *comparative* | 20.6 |
| TS-02, *comparative* | 20.6 |
| TS-04, *comparative* | 16.0 |
| TS-06, *inventive* | 12.0 |
| *Relative Coating Wear: see above. | |

The results show that the test sample comprising the blocked isocyanate compound and the binder according

to the present invention, shows a significantly improved abrasion resistance.

**IV. Printing plate precursors PPP-01 to PPP-12.**

1) Preparation of the printing plate precursors PPP-01 to PPP-12.

The printing plate precursors PPP-01 to PPP-12 were prepared by first applying onto the above described support S-01 the coating solution containing the ingredients, as defined in Table G, dissolved in a mixture of the following solvents: 57% by volume of tetrahydrofuran, 33% by volume of Dowanol PM™ (1-methoxy-2-propanol, commercially available from DOW CHEMICAL Company) and 10% by volume of gamma-butyrolactone. The coating solution was applied at a wet coating thickness of 20 μm and then dried at 135°C for 3 minutes.

Table G: Composition and dry coating weight of the first coating.

| Printing plate precursor | Polymer (1) | Polymer (1) g/m$^2$ | Crystal violet (2) g/m$^2$ | Tego glide 410 (3) g/m$^2$ | Blocked isocyanate crosslinker (4) g/m$^2$ | | |
|---|---|---|---|---|---|---|---|
| | | | | | 1 | 2 | 3 |
| PPP-01, Comp. | Polymer 1 | 0.660 | 0.01 | 0.001 | - | - | - |
| PPP-02, Comp. | Polymer 1 | 0.660 | 0.01 | 0.001 | 0.06 | - | - |
| PPP-03, Comp. | Polymer 1 | 0.660 | 0.01 | 0.001 | - | 0.06 | - |
| PPP-04, Comp. | Polymer 1 | 0.660 | 0.01 | 0.001 | - | - | 0.06 |
| PPP-05, Comp. | Polymer 2 | 0.660 | 0.01 | 0.001 | - | - | - |
| PPP-06, Comp. | Polymer 3 | 0.660 | 0.01 | 0.001 | - | - | - |
| PPP-07, inv. | Polymer 2 | 0.660 | 0.01 | 0.001 | 0.06 | - | - |
| PPP-08, inv. | Polymer 2 | 0.660 | 0.01 | 0.001 | - | 0.06 | - |
| PPP-09, comp. | Polymer 2 | 0.660 | 0.01 | 0.001 | - | - | 0.06 |
| PPP-10, inv. | Polymer 3 | 0.660 | 0.01 | 0.001 | 0.06 | - | - |
| PPP-11, inv. | Polymer 3 | 0.660 | 0.01 | 0.001 | - | 0.06 | - |
| PPP-12, comp. | Polymer 3 | 0.660 | 0.01 | 0.001 | - | - | 0.06 |

(1) See Table A above;
(2) Crystal Violet, commercially available from CIBA-GEIGY;
(3) TEGOGLIDE 410™ is a copolymer of polysiloxane and poly(alkylene oxide), commercially available from TEGO CHEMIE SERVICE GmbH;
(4) See Table C above.

Subsequently, a second coating solution containing the ingredients as defined in Table H dissolved in a mixture of the following solvents: 50 % by volume of MEK, 50 % by volume of Dowanol PM, which is 1-methoxy-2-propanol, commercially available from DOW CHEMICAL Company, was applied onto the coated support. The second coating solution was applied at a wet coating thickness of 16 μm and then dried at 125°C for 3 minutes. The dry coating weight

amount in $g/m^2$ of each of the ingredients is indicated in Table H. The printing plate precursors PPP-01 to PPP-12 were obtained.

Table H: Composition and dry coating weight of the second coating of the printing plate precursors.

| | Second coating |
|---|---|
| INGREDIENTS | $g/m^2$ |
| Alnovol SPN402 (1) | 0.653 |
| SOO94 (2) | 0.025 |
| Crystal Violet (3) | 0.010 |
| Tegoglide 410 (4) | 0.001 |
| TMCA (5) | 0.056 |

(1) Alnovol SPN402 is a 44.0 wt.% solution in Dowanol PM of a m,p-cresol-cresol-xylenol formaldehyde novolac resin commercially available from Clariant GmbH.;
(2) SOO94 is an IR absorbing cyanine dye, commercially available from FEW CHEMICALS; the chemical structure of SOO94 is as follows :

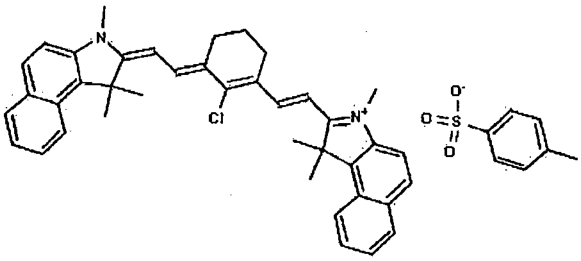

(3) Crystal Violet, commercially available from CIBA-GEIGY;
(4) TEGOGLIDE 410 is a copolymer of polysiloxane and poly(alkylene oxide), commercially available from TEGO CHEMIE SERVICE GmbH;
(5) TMCA is 3,4,5-trimethoxy cinnamic acid:

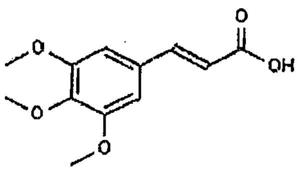

2) Imaging and processing of the printing plate precursors.

The obtained printing plate precursors PPP-01 to PPP-12 were exposed with a Creo Trendsetter 3244 (external drum platesetter available from Kodak), having a 20 W thermal head, operating at 140 rpm. The imaging resolution amounted to 2400 dpi. Each printing plate precursor was exposed to several energy densities.

Subsequently, the exposed printing plate precursors were processed in an Elantrix™ 85H processor (processing apparatus commercially available from Agfa Graphics N.V.). The developer section was filled with Energy Elite™ Improved Developer (commercially available from Agfa Graphics N.V.) and the gum/finisher section with RC795c™ (commercially available from Agfa Graphics N.V.). The developer temperature was 25°C, the developer dwell time amounted to 22s. The temperature of the front-side of the printing plate precursors, during the drying step in the processor, was inferior to 88°C (measured with THERMAX™, a surface temperature indicating strip, commercially available from TMC - range: 88-138°C).

3) Sensitivity and clean-out results.

The sensitivity was determined on the processed plates as the energy density at which the 1x1 pixel checkerboard pattern has a 52% dot area coverage (as measured with a GretagMacbeth D19C densitometer, commercially available from GretagMacbeth AG). The sensitivity results obtained for the printing plates according to the invention, i.e. the printing plates comprising the blocked isocyanate compound and the binder according to the present invention,

is similar to the sensitivity of the printing plates of the prior art.

The clean-out of the non-image parts was judged visually (Peak Stand Microscope with a 50x magnification) on each plate after imaging and processing. The results of this evaluation are given in Table I.

Table I: clean-out evaluation results.

| Printing Plate | Clean-out(non-image parts) |
|---|---|
| PP-01,Comp. | OK |
| PP-02,Comp. | OK |
| PP-03,Comp. | OK |
| PP-04,Comp. | NOK |
| PP-05,Comp. | OK |
| PP-06,Comp. | OK |
| PP-07,inv. | OK |
| PP-08,inv. | OK |
| PP-09,comp. | NOK |
| PP-10,inv. | OK |
| PP-11,inv. | OK |
| PP-12,comp. | NOK |

The clean-out results of Table I make clear that in all printing plates according to the invention (PP-07, PP-08, PP-10 and PP-11) there are no clean-out problems at the non-image parts. The comparative printing plates PP-4, PP-09 and PP-12, which contain the comparative crosslinker 3 which has a deblocking temperature of 90°C (see Table A), suffer from severe clean-out problems. The results indicate that inventive croslinkers 1 and 2 unlike crosslinker 3 do not react upon coating, imaging and developing, and hence do not cause clean-out problems.

## Claims

1. A positive-working lithographic printing plate precursor which comprises on a support having a hydrophilic surface or which is provided with a hydrophilic layer, a heat and/or light-sensitive coating including (i) an infrared absorbing agent, (ii) a compound including a blocked isocyanate group and (iii) an alkali soluble resin including a monomeric unit including a Lewis base moiety.

2. A printing plate precursor according to claim 1 wherein the compound including a blocked isocyanate group has a deblocking temperature above 90°C.

3. A printing plate precursor according to claims 1 or 2 wherein the compound including a blocked isocyanate group is represented by the following structure I:

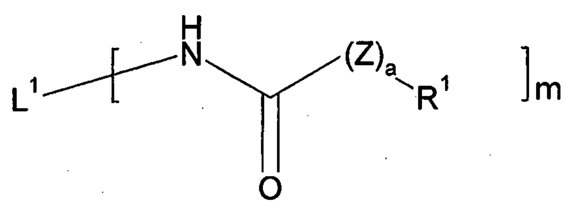

m represents an integer comprised between 2 and 100;
a represents 0 or 1;
$L^1$ represents a mono-, bi-, tri- or multivalent linking group;

Z is selected from oxygen, thiol, -NH- or -$NR^w$- wherein $R^w$ represents an optionally substituted alkyl group;
$R^1$ represents hydrogen, an optionally substituted alkyl, alkenyl, alkynyl, alicyclic, aralkyl, alkaryl, aryl or heteroaryl group such as a pyrazoyl, caprolactyl, pyridyl, pyrimidyl or pyridazyl group, an aldoxime group (-O-N=$CHR^a$) wherein $R^a$ represents an alkyl group, or a ketoxime group (-ON=$CR^bR^c$) wherein $R^b$ and $R^c$ independently represent an optionally substituted alkyl group, $R^b$ and $R^c$ may be linked.

**4.** A printing plate precursor according to claims 1 or 2 wherein the compound including a blocked isocyanate group is represented by the following structure II:

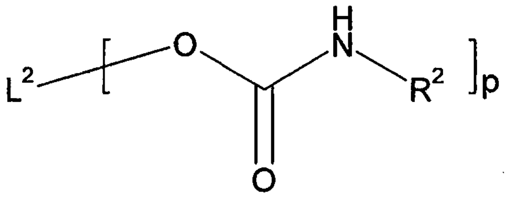

wherein

p represents an integer comprised between 2 and 100;
$L^2$ represents a mono-, bi-, tri- or multivalent linking group;
$R^2$ represents hydrogen, an optionally substituted alkyl, alkenyl, alkynyl, alicyclic, aralkyl, alkaryl, aryl or heteroaryl group such as a pyrazoyl, caprolactyl, pyridyl, pyrimidyl or pyridazyl group, an aldoxime group (-O-N=$CHR^a$) wherein $R^a$ represents an alkyl group, or a ketoxime group (-ON=$CR^bR^c$) wherein $R^b$ and $R^c$ independently represent an optionally substituted alkyl group, $R^b$ and $R^c$ may be linked.

**5.** A printing plate precursor according to claims 3 or 4 wherein $L^1$ and $L^2$ are independently selected from one of the following structures:

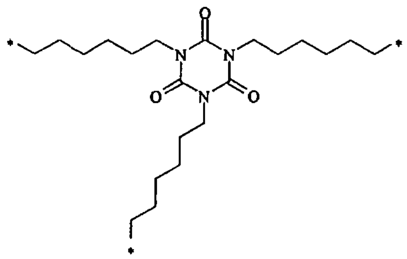
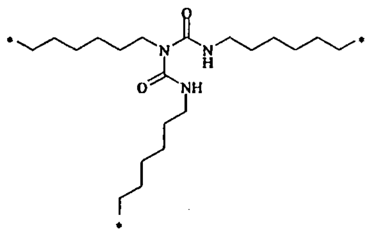
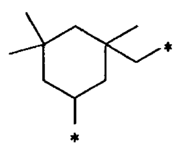

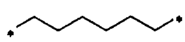
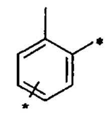
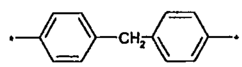

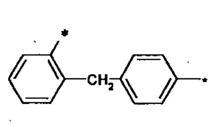
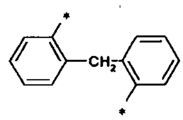
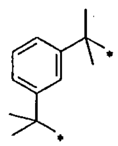

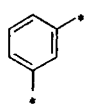
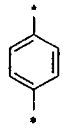
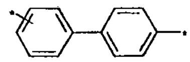

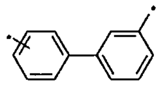
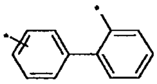
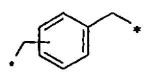

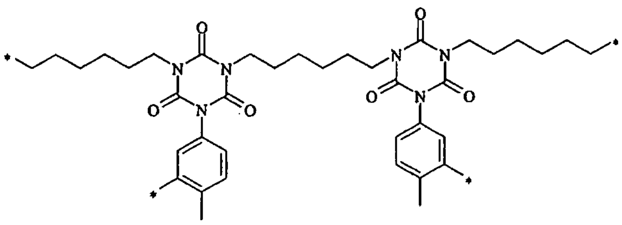
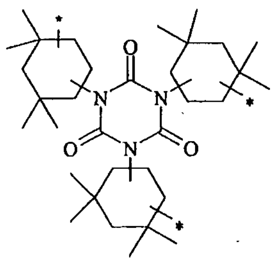

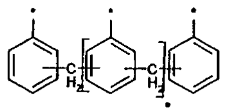

*: via this bond $L^1$ or $L^2$ is repectively attached to $-[NH-CO-(Z)_a-R^1]_m$ in structure I or to $-[O-CO-NH-R^2]_p$ in structure II.

6. A printing plate precursor according to any of the preceding claims wherein the compound including a blocked isocyanate group is present in the coating in an amount comprised between 0.005 $g/m^2$ to 1 $g/m^2$.

7. A printing plate precursor according to any of the preceding claims wherein the monomeric unit including a Lewis base moiety is represented by structure III:

$$R-(L^3)_c-(X)_n$$

wherein

R represents a structural moiety comprising an ethylenically unsatured polymerisable group;
$L^3$ represents a divalent linking group;
X represents a Lewis base moiety;
c is 0 or 1; and
n is an integer comprised between 1 and 9.

8. A printing plate precursor according to any of the preceding claims wherein the Lewis base moiety is selected from hydroxyl, thiol, an amine group of the formula $-NH_{2-x}R^d_x$ wherein $R^d$ = alkyl or aryl and x is 0 or 1; imidazoyl; triazoyl; pyridinyl; piperidinyl, a phosphine group of the formula $-PR^e_{2-y}Ar_y$ wherein $R^e$ = alkyl and Ar = aryl and y = 0, 1 or 2; three membered rings with an O, N or S heteroatom; an amide group, a thioamide group, an acid group, groups including O, S, Se and Te such as ethers and ketones, and an aldehyde group.

9. A printing plate precursor according to claims 7 or 8 wherein R represents a vinyl, vinyl ether, allyl, acrylyl, methacrylyl, acrylamidyl, methacrylamidyl, maleimidyl, norbornene functionalised maleimidyl or a cycloalkenyl group.

10. A printing plate precursor according to any of the preceding claims wherein the alkali soluble resin comprises 0.5 to 60 mol% of the monomeric unit including a Lewis base moiety.

**11.** A printing plate precursor according to any of the preceding claims wherein the alkali soluble resin further comprises a monomeric unit including a sulphonamide group represented by $-NR^j-SO_2-$, $-SO_2-NR^k-$ wherein $R^j$ and $R^k$ each independently represent hydrogen, an optionally substituted alkyl, alkanoyl, alkenyl, alkynyl, cycloalkyl, heterocyclic, aryl, heteroaryl, aralkyl, heteroaralkyl group or combinations thereof.

**12.** A printing plate precursor according to claim 11 wherein the alkali soluble resin comprises 25 to 80 mol% of the monomeric unit including a sulphonamide group.

**13.** A printing plate precursor according to any of the preceding claims wherein the coating comprises two layers, a first layer comprising the compound including a blocked isocyanate group and an alkali soluble resin including a Lewis base moiety, and a second layer located above said first layer comprising a phenolic resin.

**14.** A method for making a positive-working lithographic printing plate comprising the steps of:

a) imagewise exposing a heat-sensitive lithographic printing plate precursor according to any of the preceding claims to heat and/or infrared light;
b) developing said imagewise exposed precursor with an aqueous alkaline developer so that the exposed areas are dissolved;
c) baking the obtained plate.

**15.** A method of printing comprising the steps of:

a) providing a printing plate according to claim 14;
b) mounting the printing plate on a printing press; supplying ink and fountain solution to the printing plate;
c) transferring the ink to paper.

**Patentansprüche**

**1.** Positivarbeitende Vorstufe einer lithografischen Druckplatte, umfassend auf einem Träger mit einer hydrophilen Oberfläche oder einem mit einer hydrophilen Schicht versehenen Träger eine wärmeempfindliche und/oder lichtempfindliche Beschichtung, enthaltend (i) ein Infrarotstrahlung absorbierendes Mittel, (ii) eine eine blockierte Isocyanatgruppe enthaltende Verbindung und (iii) ein alkalilösliches Harz, das eine einen Lewis-Base-Teil enthaltende Monomereinheit umfasst.

**2.** Druckplattenvorstufe nach Anspruch 1, **dadurch gekennzeichnet, dass** die eine blockierte Isocyanatgruppe enthaltende Verbindung eine Entblockierungstemperatur über 90°C aufweist.

**3.** Druckplattenvorstufe nach Anspruch 1 oder 2, **dadurch gekennzeichnet, dass** die eine blockierte Isocyanatgruppe enthaltende Verbindung folgende Struktur I aufweist :

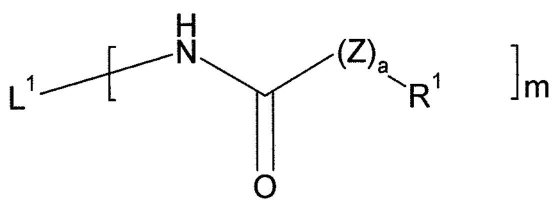

in der

m eine ganze Zahl zwischen 2 und 100 bedeutet,
a 0 oder 1 bedeutet,
$L^1$ eine ein-, zwei-, drei- oder mehrwertige Verbindungsgruppe bedeutet,
Z ein Sauerstoffatom, Thiol, -NH- oder $-NR^W-$ bedeutet, wobei $R^W$ eine gegebenenfalls substituierte Alkylgruppe bedeutet,
$R^1$ ein Wasserstoffatom, eine gegebenenfalls substituierte Alkylgruppe, Alkenylgruppe, Alkynylgruppe, alicyclische Gruppe, Aralkylgruppe, Alkarylgruppe, Arylgruppe oder Heteroarylgruppe, wie eine Pyrazoylgruppe, Caprolactylgruppe, Pyridylgruppe, Pyrimidylgruppe oder Pyridazylgruppe, eine Aldoximgruppe (-0-N=CHR$^a$), wobei R$^a$ eine Alkylgruppe bedeutet, oder eine Ketoximgruppe (-O-N=CR$^b$R$^c$), wobei R$^b$ und R$^c$ unabhängig voneinander eine gegebenenfalls substituierte Alkylgruppe bedeuten und R$^b$ und R$^C$ aneinander gebunden sein können, bedeutet.

4. Druckplattenvorstufe nach Anspruch 1 oder 2, **dadurch gekennzeichnet, dass** die eine blockierte Isocyanatgruppe enthaltende Verbindung folgende Struktur II aufweist :

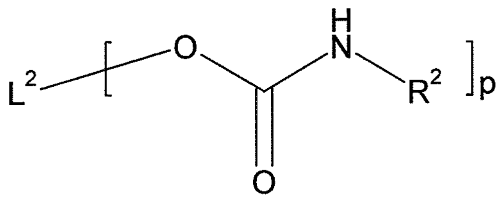

in der

p eine ganze Zahl zwischen 2 und 100 bedeutet,
L$^2$ eine ein-, zwei-, drei- oder mehrwertige Verbindungsgruppe bedeutet,
R$^2$ ein Wasserstoffatom, eine gegebenenfalls substituierte Alkylgruppe, Alkenylgruppe, Alkynylgruppe, alicyclische Gruppe, Aralkylgruppe, Alkarylgruppe, Arylgruppe oder Heteroarylgruppe, wie eine Pyrazoylgruppe, Caprolactylgruppe, Pyridylgruppe, Pyrimidylgruppe oder Pyridazylgruppe, eine Aldoximgruppe (-O-N=CHR$^a$), wobei R$^a$ eine Alkylgruppe bedeutet, oder eine Ketoximgruppe (-O-N=CR$^b$R$^c$), wobei R$^b$ und R$^c$ unabhängig voneinander eine gegebenenfalls substituierte Alkylgruppe bedeuten und R$^b$ und R$^c$ aneinander gebunden sein können, bedeutet.

5. Druckplattenvorstufe nach Anspruch 3 oder 4, **dadurch gekennzeichnet, dass** L$^1$ und L$^2$ unabhängig voneinander aus einer der folgenden Strukturen gewählt werden :

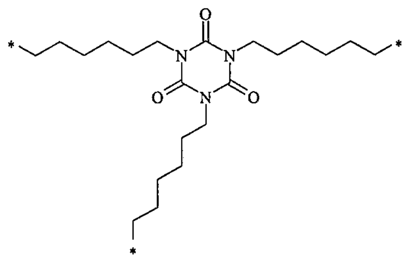
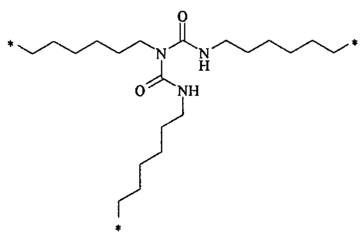
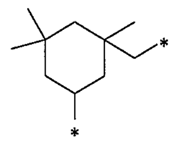

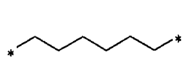
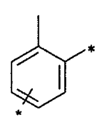
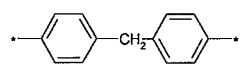

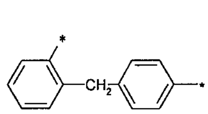
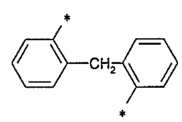
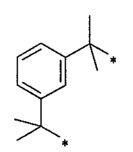

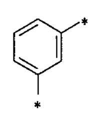
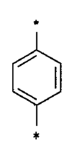
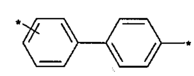

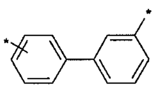

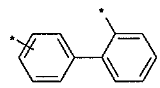

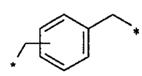

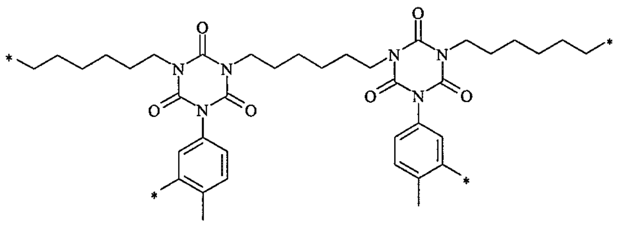

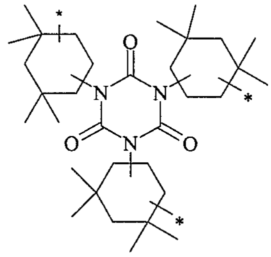

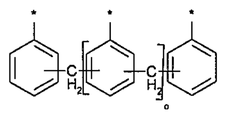

* : über diese Binding sind $L^1$ oder $L^2$ an $-[NH-CO-(Z)_a-R^1]_m$ in Struktur I bzw. an $-[O-CO-NH-R^2]_p$ in Struktur II gebunden.

6. Druckplattenvorstufe nach einem der vorstehenden Ansprüche, **dadurch gekennzeichnet, dass** die eine blockierte Isocyanatgruppe enthaltende Verbindung in einer Menge zwischen 0,005 $g/m^2$ und 1 $g/m^2$ in der Beschichtung enthalten ist.

7. Druckplattenvorstufe nach einem der vorstehenden Ansprüche, **dadurch gekennzeichnet, dass** die einen Lewis-Base-Teil enthaltende Monomereinheit folgender Struktur III entspricht :

$$R-(L^3)_c-(X)_n$$

in der

R einen eine ethylenisch ungesättigte polymerisierbare Gruppe umfassenden Strukturteil bedeutet,
$L^3$ eine zweiwertige Verbindungsgruppe bedeutet,
X einen Lewis-Base-Teil bedeutet,
c 0 oder 1 bedeutet, und
n eine ganze Zahl zwischen 1 und 9 bedeutet.

8. Druckplattenvorstufe nach einem der vorstehenden Ansprüche, **dadurch gekennzeichnet, dass** der Lewis-Base-Teil Hydroxyl, Thiol, eine Aminogruppe der Formel $-NH_{2-x}R^d_x$, wobei $R^d$ = Alkyl oder Aryl und x = 0 oder 1, Imidazoyl, Triazoyl, Pyridinyl, Piperidinyl, eine Phosphingruppe der Formel $-PR^e_{2-y}Ar_y$, wobei $R^e$ = Alkyl und Ar = Aryl und y = 0, 1 oder 2, dreigliedrige Ringe mit einem O-, N- oder S-Heteroatom, eine Amidgruppe, eine Thioamidgruppe, eine Säuregruppe, O-, S-, Se- und Te-haltige Gruppen, wie Ether und Ketone, oder eine Aldehydgruppe bedeutet.

9. Druckplattenvorstufe nach Anspruch 7 oder 8, **dadurch gekennzeichnet, dass** R eine Vinylgruppe, Vinylethergruppe, Allylgruppe, Acrylylgruppe, Methacrylylgruppe, Acrylamidylgruppe, Methacrylamidylgruppe, Maleimidylgruppe, eine Norbornenfunktionalisierte Maleimidylgruppe oder eine Cycloalkenylgruppe bedeutet.

10. Druckplattenvorstufe nach einem der vorstehenden Ansprüche, **dadurch gekennzeichnet, dass** das alkalilösliche Harz zwischen 0,5 und 60 mol-% der einen Lewis-Base-Teil enthaltenden Monomereinheit enthält.

11. Druckplattenvorstufe nach einem der vorstehenden Ansprüche, **dadurch gekennzeichnet, dass** das alkalilösliche Harz ferner eine Monomereinheit umfasst, die eine durch $-NR^j-SO_2-$, $-SO_2-NR^k-$dargestellte Sulfonamidgruppe umfasst, wobei $R^j$ und $R^k$ unabhängig voneinander jeweils ein Wasserstoffatom, eine gegebenenfalls substituierte Alkylgruppe, Alkanoylgruppe, Alkenylgruppe, Alkynylgruppe, Cycloalkylgruppe, heterocyclische Gruppe, Arylgruppe, Heteroarylgruppe, Aralkylgruppe, Heteroaralkylgruppe oder Kombinationen derselben bedeuten.

**12.** Druckplattenvorstufe nach Anspruch 11, **dadurch gekennzeichnet, dass** das alkalilösliche Harz zwischen 25 und 80 mol-% der eine Sulfonamidgruppe enthaltenden Monomereinheit enthält.

**13.** Druckplattenvorstufe nach einem der vorstehenden Ansprüche, **dadurch gekennzeichnet, dass** die Beschichtung zwei Schichten umfasst, wobei eine erste Schicht die eine blockierte Isocyanatgruppe enthaltende Verbindung und ein alkalilösliches, einen Lewis-Base-Teil enthaltenden Harz enthält und eine zweite Schicht auf die erste Schicht aufgetragen ist und ein Phenolharz enthält.

**14.** Verfahren zur Herstellung einer positivarbeitenden lithografischen Druckplatte, umfassend die folgenden Schritte :

a) bildmäßiges Erwärmen und/oder Belichten mit Infrarotstrahlung einer wärmeempfindlichen Vorstufe einer lithografischen Druckplatte nach einem der vorstehenden Ansprüche,
b) Entwicklung der bildmäßig erwärmten bzw. belichteten Vorstufe mit einem wässrig-alkalischen Entwickler, wodurch die erwärmten bzw. belichteten Bereiche aufgelöst werden,
c) Einbrennen der so erhaltenen Platte.

**15.** Druckverfahren, das die folgenden Schritte umfasst :

a) Bereitstellen einer Druckplatte nach Anspruch 14,
b) Einspannen der Druckplatte in eine Druckmaschine und Einfärben und Benetzen der Druckplatte mit Druckfarbe bzw. Feuchtwasser,
c) Übertragen der Druckfarbe auf Papier.

## Revendications

**1.** Précurseur positif d'une plaque d'impression lithographique comprenant, sur un support ayant une surface hydrophile ou un support revêtu d'une couche hydrophile, un revêtement thermosensible et/ou photosensible contenant (i) un agent absorbant les rayons infrarouges, (ii) un composé contenant un groupe isocyanate bloqué et (iii) une résine soluble dans les alcalis comprenant un motif monomère comprenant une fraction d'acide de Lewis.

**2.** Précurseur de plaque d'impression selon la revendication 1, **caractérisé en ce que** ledit composé contenant un groupe isocyanate bloqué présente une température de déblocage supérieure à 90°C.

**3.** Précurseur de plaque d'impression selon la revendication 1 ou 2, **caractérisé en ce que** ledit composé contenant un groupe isocyanate bloqué présente la structure I suivante :

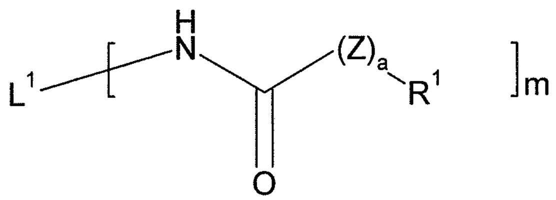

où

m représente un nombre entier de 2 à 100,
a représente 0 ou 1,
$L^1$ représente un groupe de liaison monovalent, bivalent, trivalent ou multivalent,
Z représente un atome d'oxygène, un groupe thiol, -NH- ou -$NR^W$-, où $R^W$ représente un groupe alkyle éventuellement substitué,
$R^1$ représente un atome d'hydrogène, un groupe alkyle éventuellement substitué, un groupe alkényle éventuellement substitué, un groupe alkynyle éventuellement substitué, un groupe alicyclique éventuellement substitué, un groupe aralkyle éventuellement substitué, un groupe alkaryle éventuellement substitué, un groupe aryle éventuellement substitué ou un groupe hétéroaryle éventuellement substitué, tels qu'un groupe pyrazoyle, un groupe caprolactyle, un groupe pyridyle, un groupe pyrimidyle ou un groupe pyridazyle, un groupe aldoxime (-O-N=$CHR^a$), où $R^a$ représente un groupe alkyle, ou un groupe cétoxime (-O-N=$CR^bR^c$), où $R^b$ et $R^c$ représentent, indépendamment l'un de l'autre, un groupe alkyle éventuellement substitué et $R^b$ et $R^c$ peuvent être liés entre eux.

4. Précurseur de plaque d'impression selon la revendication 1 ou 2, **caractérisé en ce que** ledit composé contenant un groupe isocyanate bloqué présente la structure II suivante :

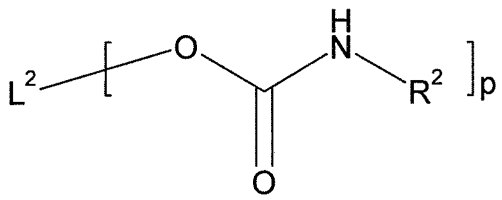

où

p représente un nombre entier de 2 a 100,
$L^2$ représente un groupe de liaison monovalent, bivalent, trivalent ou multivalent,
$R^2$ représente un atome d'hydrogène, un groupe alkyle éventuellement substitué, un groupe alkényle éventuellement substitué, un groupe alkynyle éventuellement substitué, un groupe alicyclique éventuellement substitué, un groupe aralkyle éventuellement substitué, un groupe alkaryle éventuellement substitué, un groupe aryle éventuellement substitué ou un groupe hétéroaryle éventuellement substitué, tels qu'un groupe pyrazoyle, un groupe caprolactyle, un groupe pyridyle, un groupe pyrimidyle ou un groupe pyridazyle, un groupe aldoxime (-O- N=CHR$^a$), où $R^a$ représente un groupe alkyle, ou un groupe cétoxime (-O-N=CR$^b$R$^c$), où $R^b$ et $R^c$ représentent, indépendamment l'un de l'autre, un groupe alkyle éventuellement substitué et $R^b$ et $R^c$ peuvent être liés entre eux.

5. Précurseur de plaque d'impression selon la revendication 3 ou 4, **caractérisé en ce que** $L^1$ et $L^2$ sont choisis, indépendamment l'un de l'autre, parmi une des structures reprises ci-après :

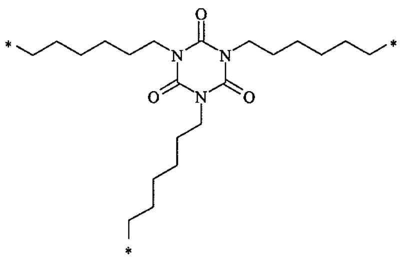
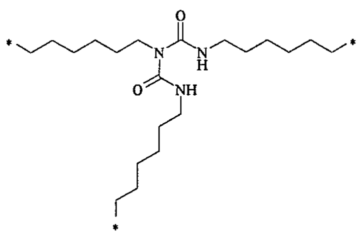
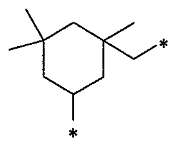

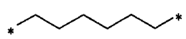
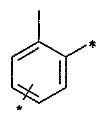
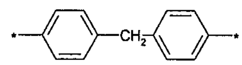

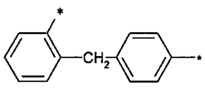
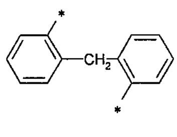
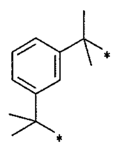

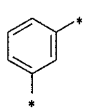
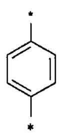
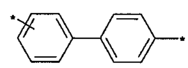

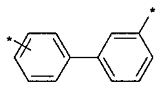

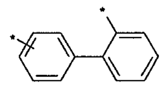

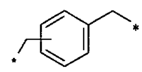

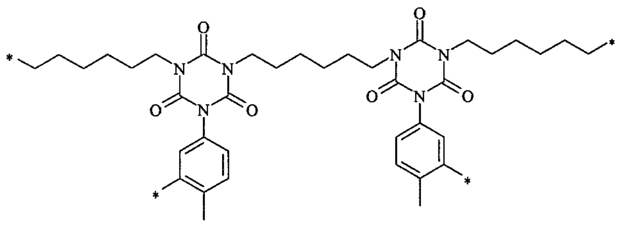

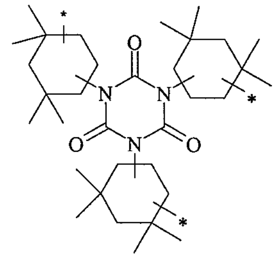

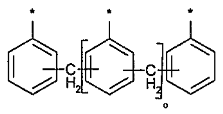

* : cette liaison assure la liaison de $L^1$ ou $L^2$ respectivement à $-[NH-CO-(Z)_a-R^1]_m$ dans la structure I et à $-[O-CO-NH-R^2]_p$ dans la structure II.

6. Précurseur de plaque d'impression selon l'une quelconque des revendications précédentes, **caractérisé en ce que** la quantité dudit composé contenant un groupe isocyanate bloqué dans le revêtement est comprise entre 0,005 $g/m^2$ et 1 $g/m^2$.

7. Précurseur de plaque d'impression selon l'une quelconque des revendications précédentes, **caractérisé en ce que** le motif monomère contenant une fraction d'acide de Lewis présente la structure III suivante :

$$R-(L^3)_c-(X)_n$$

où

R représente une fraction structurale comprenant un groupe polymérisable éthyléniquement insaturé,
$L^3$ représente un groupe de liaison bivalent,
X représente une fraction d'acide de Lewis,
c représente 0 ou 1, et
n représente un nombre entier de 1 à 9.

8. Précurseur de plaque d'impression selon l'une quelconque des revendications précédentes, **caractérisé en ce que** la fraction d'acide de Lewis est choisie parmi un groupe hydroxyle, un groupe thiol, un groupe amino répondant à la formule $-NH_{2-x}R^d_x$, où $R^d$ = alkyle ou aryle et x = 0 ou 1, un groupe imidazoyle, un groupe triazoyle, un groupe pyridinyle, un groupe pipéridinyle, un groupe phosphine répondant à la formule $-PR^e_{2-y}Ar_y$, où $R^e$ = alkyle et Ar = aryle et y = 0, 1 ou 2, des noyaux à trois membres comprenant un hétéroatome d'oxygène, un hétéroatome d'azote ou un hétéroatome de soufre, un groupe amide, un groupe thioamide, un groupe acide, des groupes comprenant de l'oxygène, du soufre, du sélénium et du tellure, tels que des éthers et des cétones, ou un groupe aldéhyde.

9. Précurseur de plaque d'impression selon la revendication 7 ou 8, **caractérisé en ce que** R représente un groupe vinyle, un groupe éther vinylique, un groupe allyle, un groupe acrylyle, un groupe méthacrylyle, un groupe acrylamidyle, un groupe méthacrylamidyle, un groupe maléimidyle, un groupe maléimidyle à fonction norbornène ou un groupe cycloalkényle.

10. Précurseur de plaque d'impression selon l'une quelconque des revendications précédentes, **caractérisé en ce que** la résine soluble dans les alcalis contient de 0,5 à 60% en moles du motif monomère comprenant une fraction d'acide de Lewis.

11. Précurseur de plaque d'impression selon l'une quelconque des revendications précédentes, **caractérisé en ce que**

la résine soluble dans les alcalis comprend en outre un motif monomère comprenant un groupe sulfonamide représenté par $-NR^j-SO_2-$, $-SO_2-NR^k-$, où $R^j$ et $R^k$ représentent chacun, indépendamment l'un de l'autre, un atome d'hydrogène, un groupe alkyle éventuellement substitué, un groupe alkanoyle éventuellement substitué, un groupe alkényle éventuellement substitué, un groupe alkynyle éventuellement substitué, un groupe cycloalkyle éventuellement substitué, un groupe hétérocyclique éventuellement substitué, un groupe aryle éventuellement substitué, un groupe hétéroaryle éventuellement substitué, un groupe aralkyle éventuellement substitué, un groupe hétéroaralkyle éventuellement substitué ou des combinaisons de ceux-ci.

**12.** Précurseur de plaque d'impression selon la revendication 11, **caractérisé en ce que** la résine soluble dans les alcalis contient de 25 à 80% en moles du motif monomère comprenant un groupe sulfonamide.

**13.** Précurseur de plaque d'impression selon l'une quelconque des revendications précédentes, **caractérisé en ce que** le revêtement comprend deux couches, une première couche contenant le composé contenant un groupe isocyanate bloqué et une résine soluble dans les alcalis contenant une fraction d'acide de Lewis et une deuxième couche appliquée sur ladite première couche et contenant une résine phénolique.

**14.** Procédé pour la confection d'une plaque d'impression lithographique positive, comprenant les étapes consistant à :

a) exposer sous forme d'image à de la chaleur et/ou à des rayons infrarouges un précurseur thermosensible d'une plaque d'impression lithographique selon l'une quelconque des revendications précédentes,
b) développer le précurseur exposé sous forme d'image en utilisant un révélateur alcalin aqueux de façon à dissoudre les zones exposées,
c) cuire la plaque ainsi obtenue.

**15.** Procédé d'impression comprenant les étapes consistant à :

a) mettre à disposition une plaque d'impression selon la revendication 14,
b) serrer la plaque d'impression dans une machine à imprimer et encrer et mouiller la plaque d'impression,
c) transférer l'encre sur papier.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 625728 A
- EP 823327 A
- EP 825927 A
- EP 864420 A
- EP 894622 A
- EP 901902 A
- EP 1588860 A
- EP 933682 A
- EP 982123 A
- EP 1072432 A
- WO 9963407 A
- EP 1400351 A
- WO 07099047 A
- EP 2159049 A
- DE 4007428
- DE 4027301
- DE 4445820
- DE 4007428 A
- DE 4027301 A
- DE 4445820 A
- EP 934822 A
- US 5641608 A
- WO 9901795 A
- WO 04035310 A
- WO 04035686 A
- WO 04035645 A
- WO 04035687 A
- EP 1506858 A
- WO 9739894 A
- EP 978376 A
- EP 1029667 A
- EP 1053868 A
- EP 1093934 A
- WO 0029214 A
- EP 400706 A
- WO 2006005688 A
- EP 1356926 A
- EP 1025992 A
- WO 9921715 A
- EP 1074386 A
- EP 1074889 A
- WO 04030923 A
- WO 04030924 A
- WO 04030925 A
- US 5174205 A
- US 5163368 A
- EP 1614538 A
- EP 1614539 A
- EP 1614540 A
- WO 2004071767 A
- EP 1342568 A
- WO 2005111727 A
- EP 1588220 A
- EP 1916101 A
- DE 1447963
- GB 1154749 A
- EP 1506854 A
- US 4045232 A
- US 4981517 A
- US 6140392 A
- WO 0032705 A

### Non-patent literature cited in the description

- **HOFMANN et al.** *Makromoleculare Chemie,* 1976, vol. 177, 1791-1813